# EUROPEAN PATENT APPLICATION

(11) **EP 4 492 142 A1**
(43) Date of publication of application: **15.01.2025**
(21) Application number: 23766909.8
(22) Date of filing: 09.03.2023
(51) Int. Cl.: G03F 7/004, G03F 7/038, G03F 7/11, G03F 7/20

(54) **WAFER EDGE PROTECTIVE FILM-FORMING COMPOSITION FOR SEMICONDUCTOR MANUFACTURING**

(30) Priority: 10.03.2022 JP 2022037045
(71) Applicant: Nissan Chemical Corporation, Tokyo 103-6119 (JP)
(72) Inventor: MORIYA Shunsuke, Toyama-shi, Toyama 939-2792 (JP); KISHIOKA Takahiro, Toyama-shi, Toyama 939-2792 (JP)
(74) Representative: Hoffmann Eitle
(86) International application number: PCT/JP2023/008951
(87) International publication number: WO 2023/171733

(57) **Abstract**

A wafer end protective-film forming composition for semiconductor manufacturing including: a polymer or compound having a crosslinkable group, and a solvent, wherein the solvent contains a first solvent and a second solvent, and when an evaporation rate of n-butyl acetate is 1, an evaporation rate of the first solvent is 0.10 or more and an evaporation rate of the second solvent is 0.05 or less.

## Description

### Technical Field

The present invention relates to a protective-film forming composition for forming a protective film of a front surface end portion and a bevel portion of a substrate (wafer) for semiconductor manufacturing in a semiconductor device manufacturing process, a protective film formed of the protective-film forming composition, a wafer for semiconductor manufacturing manufactured using the protective film, and methods for manufacturing the wafer for semiconductor manufacturing and a semiconductor device.

### Background Art

In the manufacture of a semiconductor device, a method of applying a chemical solution containing a metal to a wafer has been studied for the purpose of, for example, improving an etching selectivity ratio along with complication of a manufacturing process. Furthermore, for example, since the resolution of a resist pattern in the case of performing exposure using extreme ultraviolet rays (EUV) is increased and high etching resistance is exhibited, it has been studied to form a resist film using a resist containing an inorganic metal. Incidentally, adhesion of metal to an unscheduled portion of the wafer in the manufacturing process of the semiconductor device greatly affects the electrical characteristics of the semiconductor device. However, in forming the coating film containing metal as described above, the chemical solution supplied to the front surface of the wafer goes around to the peripheral edge portion of the peripheral end surface and the back surface of the wafer, and the coating film is formed even to the unscheduled peripheral end surface and the back surface peripheral edge portion, so that there is a concern that these portions are contaminated with metal. Then, when the contaminated part of the wafer comes into contact with a processing device of the wafer such as an exposure device and an etching device or a conveyance mechanism of the wafer, a wafer conveyed and processed after the wafer via the processing device or the conveyance mechanism may also be contaminated with metal; that is, cross-contamination may occur.

In forming a coating film on a surface of a substrate, a technique is disclosed in which the coating film can be formed so that a peripheral end surface and a back side peripheral portion that are peripheral portions of the substrate do not come into contact with the coating film (Patent Literature 1).

A method for manufacturing a semiconductor device in which peeling of a film from a bevel portion of a substrate is suppressed is disclosed (Patent Literature 2).

### Citation List

### Patent Literature

Patent Literature 1: JP 2017-098333 A
Patent Literature 2: JP 2011-228340 A

### Summary of Invention

### Technical Problem

An object of the present invention is to provide a protective-film forming composition capable of forming a protective film having a good film state without an abnormal shape (partial swelling or recess) at a front surface end portion or a bevel portion of a substrate (wafer) for semiconductor manufacturing by a simple method by coating in manufacturing a semiconductor device, a protective film formed of the protective-film forming composition, a wafer for semiconductor manufacturing manufactured using the protective film, and methods for manufacturing a wafer for semiconductor manufacturing and a semiconductor device.

### Solution to Problem

The present invention includes the followings.
[1] A wafer end protective-film forming composition for semiconductor manufacturing including:
   a polymer or a compound having a crosslinkable group, and a solvent,
   wherein the solvent contains a first solvent and a second solvent, and
   when an evaporation rate of n-butyl acetate is 1, an evaporation rate of the first solvent is 0.10 or more and an evaporation rate of the second solvent is 0.05 or less.
[2] The wafer end protective-film forming composition for semiconductor manufacturing according to [1], wherein a mass ratio (S1 : S2) between the first solvent (S1) and the second solvent (S2) is 50 : 50 to 95 : 5.
[3] The wafer end protective-film forming composition for semiconductor manufacturing according to [1] or [2], wherein a difference (V1 - V2) between the evaporation rate (V1) of the first solvent and the evaporation rate (V2) of the second solvent is 0.10 or more.
[4] The wafer end protective-film forming composition for semiconductor manufacturing according to any one of [1] to [3],
   wherein constituent elements of the first solvent are carbon, oxygen, and hydrogen, and
   constituent elements of the second solvent are carbon, oxygen, and hydrogen.
[5] The wafer end protective-film forming composition for semiconductor manufacturing according to any one of [1] to [4], wherein a content of the solvent is 70 mass% to 99 mass%.
[6] The wafer end protective-film forming composition for semiconductor manufacturing according to any one of [1] to [5], having a viscosity of 100 cps or less at 25°C.
[7] The wafer end protective-film forming composition for semiconductor manufacturing according to any one of [1] to [6], which is photosensitive.
[8] The wafer end protective-film forming composition for semiconductor manufacturing according to any one of [1] to [7], wherein the crosslinkable group is selected from the group consisting of an epoxy group, a (meth)acrylic group, a vinyl group, a carboxy group, a thiol group, a silanol group, a cinnamoyl group, and a hydroxy group.
[9] A protective film that is a cured product of a coating film formed of the wafer end protective-film forming composition for semiconductor manufacturing according to any one of [1] to [8].
[10] The protective film according to [9], having a thickness of 1 to 10,000 nm.
[11] The protective film according to [9] or [10], which is a protective film preventing metal contamination of a front surface end portion and a bevel portion of a wafer.
[12] The protective film according to any one of [9] to [11], which is cured by being irradiated with light having a wavelength of 170 to 800 nm.
[13] A wafer for semiconductor manufacturing including a front surface end portion and a bevel portion of a wafer protected, wherein a protective film is formed by applying the wafer end protective-film forming composition for semiconductor manufacturing according to any one of [1] to [8] to the front surface end portion and the bevel portion of a wafer precursor.
[14] A method for manufacturing a semiconductor device, the method including:
   a step (A) of forming a resist film on a semiconductor substrate;
   a step (B) of forming a resist pattern by irradiating the resist film with light or an electron beam and subsequently performing development;
   a step (C) of etching the semiconductor substrate using the resist pattern as a mask; and
   a step (X) of forming a protective film on a front surface end portion, a bevel portion, and optionally a back surface end portion of a wafer for semiconductor manufacturing using the wafer end protective-film forming composition for semiconductor manufacturing according to any one of [1] to [8].
[15] The method for manufacturing a semiconductor device according to [14], wherein the step (X) is performed before the step (A).
[16] The method for manufacturing a semiconductor device according to [14], wherein the step (X) is performed between the step (A) and the step (B).
[17] The method for manufacturing a semiconductor device according to [14], wherein the step (X) is performed after the step (B) or the step (C).
[18] The method for manufacturing a semiconductor device according to [14],
   wherein the step (X) is performed before the step (A),
   the resist film is formed on at least a part of the protective film in the step (A), and
   a step (Y) of removing the resist film on the protective film is included.
[19] The method for manufacturing a semiconductor device according to any one of [14] to [18], including a step (Z) of removing the protective film.
[20] The method for manufacturing a semiconductor device according to [18], including a step (Z) of removing the protective film after the step (Y).
[21] The method for manufacturing a semiconductor device according to any one of [14] to [20], wherein the resist film contains a metal.
[22] The method for manufacturing a semiconductor device according to any one of [14] to [21],
   wherein the wafer end protective-film forming composition for semiconductor manufacturing is photosensitive, and
   formation of the protective film in the step (X) is performed by applying the wafer end protective-film forming composition for semiconductor manufacturing, and performing exposure on a predetermined region and development.
[23] The method for manufacturing a semiconductor device according to any one of [14] to [22], wherein formation of the protective film in the step (X) is performed by spin coating with the wafer end protective-film forming composition for semiconductor manufacturing.
[24] The method for manufacturing a semiconductor device according to [19] or [20], wherein the protective film is removed in the step (Z) by ashing or by treatment with hydrofluoric acid, an organic solvent, an alkaline developer, or a cleaning liquid for a semiconductor.
[25] A method for manufacturing a wafer for semiconductor manufacturing, the method including:
   a step of applying the wafer end protective-film forming composition for semiconductor manufacturing according to any one of [1] to [8] to an end portion of a wafer precursor to manufacture a wafer including a front surface end portion and a bevel portion protected by the protective film formed.

### Advantageous Effects of Invention

According to the present invention, in the manufacture of a semiconductor device, a protective film having a good film state without an abnormal shape (partial swelling or recess) can be formed at a front surface end portion and a bevel portion of a substrate (wafer) for semiconductor manufacturing by a simple method by coating. As a result, in the subsequent part of the semiconductor device manufacturing process, cross contamination due to metal contamination can be prevented, and the yield of good semiconductor manufacturing apparatuses can be improved.

### Description of Embodiments

### (Wafer End Protective-Film Forming Composition for Semiconductor Manufacturing)

A wafer end protective-film forming composition for semiconductor manufacturing (hereinafter, it may be referred to as a "protective-film forming composition") of the present invention is a protective-film forming composition used for protecting a front surface end portion and a bevel portion of a wafer for semiconductor manufacturing.

The protective-film forming composition contains a polymer or compound having a crosslinkable group and a solvent.

### <Solvent>

The solvent contains a first solvent and a second solvent.

Here, the evaporation rate used in the present invention is an evaporation rate obtained according to ASTM D 3539. However, the numerical value of the evaporation rate used in the present invention is a relative value with respect to the evaporation rate of n-butyl acetate. That is, the numerical value of the evaporation rate used in the present invention is a value obtained by dividing the evaporation rate of the solvent by the evaporation rate of n-butyl acetate.

When the evaporation rate of n-butyl acetate is set to 1, the evaporation rate of the first solvent is 0.10 or more, and the evaporation rate of the second solvent is 0.05 or less.

The present inventors have conducted intensive studies in order to form a protective film having a good film state by a simple method by coating on an end portion (front surface end portion and bevel portion) of a wafer for semiconductor manufacturing.

When various solvents were tried as a solvent of the protective-film forming composition, it was found that the evaporation rate affected the covering property of the front surface end portion and the film shape of the bevel portion.

For example, it has been found that when a solvent having a high evaporation rate (easy to evaporate) is used alone as the solvent of the protective-film forming composition, the covering property of the front surface end portion is improved, but the film shape of the bevel portion is deteriorated (for example, partial swelling or recess occurs). On the other hand, it has been found that when a solvent having a low evaporation rate (hardly evaporates) is used alone, the film shape of the bevel portion is improved, but the covering property of the front surface end portion is deteriorated (the film thickness is reduced). Furthermore, even when a solvent having an intermediate evaporation rate was used alone, it was difficult to achieve both.

That is, it has been found that it is difficult to improve both the covering property of the front surface end portion and the film shape of the bevel portion with only one kind of solvent.

Therefore, the present inventors have found that by using two or more kinds of solvents having different evaporation rates in combination, a protective film having a good film state can be formed by a simple method by coating on an end portion (front surface end portion and bevel portion) of a wafer for semiconductor manufacturing, and have completed the present invention.

The film shape of the end portion (front surface end portion and bevel portion) of the wafer for semiconductor manufacturing can be observed with, for example, a scanning electron microscope (the magnification is, for example, 20 to 400 times, 30 to 200 times, 40 to 100 times, 50 times, 80 times, or 100 times). The abnormal shapes are observed at 10 or less points, preferably 5 or less points, more preferably 3 or less points, still more preferably 1 or less point, and most preferably no abnormal shape is observed in the visual field by the scanning electron microscope observation (0 (zero) abnormal points).

The first solvent and the second solvent are organic solvents.

The evaporation rate of the first solvent is 0.10 or more, preferably 0.10 to 0.80, more preferably 0.20 to 0.60, particularly preferably 0.30 to 0.50.

The evaporation rate of the second solvent is 0.05 or less, preferably 0.04 or less, more preferably 0.03 or less.

The difference (V1 - V2) between the evaporation rate (V1) of the first solvent and the evaporation rate (V2) of the second solvent is not particularly limited but is preferably 0.10 or more, more preferably 0.15 or more, particularly preferably 0.20 or more from the viewpoint of suitably obtaining the effect of the present invention. The difference (V1 - V2) is preferably 0.70 or less, more preferably 0.60 or less, particularly preferably 0.50 or less.

The mass ratio (S1 : S2) between the first solvent (S1) and the second solvent (S2) is not particularly limited but is preferably 50 : 50 to 95 : 5, more preferably 60 : 40 to 93 : 7, particularly preferably 70 : 30 to 90 : 10 from the viewpoint of suitably obtaining the effect of the present invention.

The constituent elements of the first solvent are, for example, carbon, oxygen, and hydrogen.

The constituent elements of the second solvent are, for example, carbon, oxygen, and hydrogen.

The first solvent preferably contains no nitrogen atom and no halogen atom as constituent elements.

The second solvent preferably contains no nitrogen atom and no halogen atom as constituent elements.

The first solvent contains, for example, at least one of an ether bond, an ester bond, and a carbonyl group.

The second solvent contains, for example, at least one of an ether bond, an ester bond, and a carbonyl group.

Here, an example of the evaporation rate (the evaporation rate of n-butyl acetate is set to 1) is shown below.

**[Table 1]**

| Solvent | Boiling point (°C) | Flash point (°C) | Evaporation rate (n-butyl acetate = 1) |
|---|---|---|---|
| Propylene glycol monomethyl ether | 120 | 32 | 0.71 |
| Methyl 2-hydroxoisobutyrate | 137 | 45 | 0.37 |
| Propylene glycol monomethyl ether acetate | 146 | 42 | 0.34 |
| 3-Methoxybutyl acetate | 171 | 63 | 0.34 |
| Ethyl lactate | 154 | 59 | 0.23 |
| Cyclohexanone | 153 | 46 | 0.23 |
| Propylene glycol n-propyl ether | 140-160 | 48 | 0.21 |
| Propylene glycol n-butyl ether | 170 | 62 | 0.07 |
| Propylene glycol diacetate (1,2-Diacetoxypropane) | 190 | 93 | 0.04 |
| Dipropylene glycol methyl ether | 190 | 79 | 0.03 |
| Dipropylene glycol methyl ether acetate | 213 | 98 | 0.02 |
| Diethylene glycol monoethyl ether acetate | 217 | 105 | 0.01 |
| 1,4-Butanediol diacetate | 232 | 116 | 0.01 or less |
| 1,3-Butylene glycol diacetate | 232 | 100 | 0.01 or less |
| Diethylene glycol monobutyl ether acetate | 247 | 124 | 0.00 |
| 1,6-Hexanediol diacetate | 260 | 138 | 0.01 or less |

The solvent may contain an organic solvent other than the first solvent and the second solvent.

The total ratio of the first solvent and the second solvent in the solvent is not particularly limited but is preferably 50 mass% to 100 mass%, more preferably 75 mass% to 100 mass%, particularly preferably 90 mass% to 100 mass%.

The content of the solvent in the protective-film forming composition is not particularly limited but is preferably 70 mass% to 99 mass%, more preferably 75 mass% to 98 mass%, particularly preferably 80 mass% to 95 mass%.

The total content of the first solvent and the second solvent in the protective-film forming composition is not particularly limited but is preferably 50 mass% to 99 mass%, more preferably 60 mass% to 98 mass%, particularly preferably 75 mass% to 95 mass%.

### <Polymer or Compound Having Crosslinkable Group>

The crosslinkable group means a group capable of forming a crosslinked structure by the action of light, an electron beam, other electromagnetic waves, a radical, an acid, heat, water, oxygen, or the like. Examples thereof include an epoxy group, a (meth)acrylic group, a vinyl group, a carboxy group, a thiol group, a silanol group, a cinnamoyl group, and a hydroxy group (including a phenolic hydroxy group) but are not limited thereto.

In the present specification, the "polymer" and the "compound" do not necessarily mean separate substances, and a substance containing a polymer may be referred to as a "compound".

The protective film (cured film) using the "polymer" and the "compound" exhibits solubility in a developer, for example, achieving a residual film ratio of a cured film in an exposed portion of 80% or more, preferably 90% or more with respect to a film in an unexposed portion in an evaluation according to "[5] Evaluation of Curability After Exposure" in the Examples section described later.

Examples of the polymer or compound having a crosslinkable group include, but are not limited to, the following.
- Epoxy (meth)acrylate (such as a reaction product of a glycidyl etherified product of a cresol novolac resin and (meth)acrylic acid),
- cinnamic acid grafted epoxy novolac,
- phenoplast, which is a thermosetting material obtained by polycondensation of phenol and an aldehyde involving removal of water and formation of a three-dimensional network,
- melamine resins such as trimethylolmelamine and hexamethylolmelamine, urea-based resins such as dimethylol propylene urea, dimethylol ethylene urea, and dimethylol hydroxyurea, aminoblast resins such as dimethyloluron resins,
- (blocked) isocyanates,
- vinyl ethers,
- polysiloxane resins having (meth)acrylic groups, and
- epoxy resins.

Here, an example of the polymer or compound having a crosslinkable group will be described.

An example of the polymer or compound having a crosslinkable group is a polymer having a structural unit represented by Formula (1-1) below. 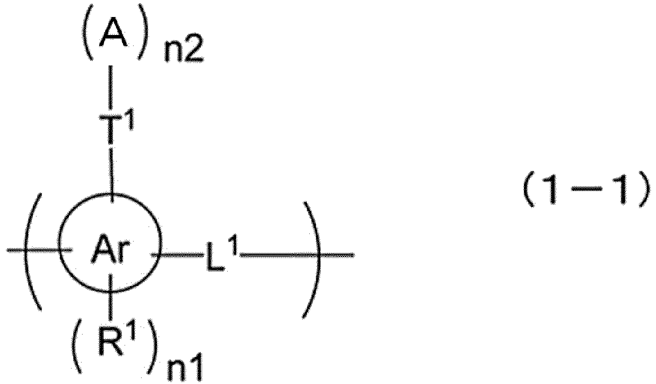 (In Formula (1-1), Ar represents a benzene ring, a naphthalene ring, or an anthracene ring, R¹ represents a hydroxy group, a mercapto group that may be protected by a methyl group, an amino group that may be protected by a methyl group, a halogeno group, or an alkyl group having 1 to 10 carbon atoms that may be substituted or interrupted by a heteroatom or substituted by a hydroxy group, n1 represents an integer of 0 to 3, L¹ represents a single bond or an alkylene group having 1 to 10 carbon atoms, n2 represents 1 or 2, A represents a group having a (meth)acryloyloxy group, and T¹ represents a single bond or an alkylene group having 1 to 10 carbon atoms that may be interrupted by an ether bond, an ester bond, or an amide bond when n2 = 1, and T¹ represents a nitrogen atom or an amide bond when n2 = 2.)

Examples of the alkyl group having 1 to 10 carbon atoms include a methyl group, an ethyl group, a n-propyl group, an i-propyl group, a cyclopropyl group, a n-butyl group, an i-butyl group, a s-butyl group, a t-butyl group, a cyclobutyl group, a 1-methyl-cyclopropyl group, a 2-methyl-cyclopropyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, a decyl group, a methoxy group, an ethoxy group, a methoxymethyl group, an ethoxymethyl group, a methoxyethyl group, an ethoxyethyl group, a hydroxymethyl group, a 1-hydroxyethyl group, a 2-hydroxyethyl group, a methylamino group, a dimethylamino group, a diethylamino group, an aminomethyl group, a 1-aminoethyl group, a 2-aminoethyl group, a methylthio group, an ethylthio group, a mercaptomethyl group, a 1-mercaptoethyl group, and a 2-mercaptoethyl group.

Examples of the alkylene group having 1 to 10 carbon atoms include a methylene group, an ethylene group, a n-propylene group, an isopropylene group, a cyclopropylene group, a n-butylene group, an isobutylene group, a s-butylene group, a t-butylene group, a cyclobutylene group, a 1-methyl-cyclopropylene group, a 2-methyl-cyclopropylene group, a n-pentylene group, a 1-methyl-n-butylene group, a 2-methyl-n-butylene group, a 3-methyl-n-butylene group, a 1,1-dimethyl-n-propylene group, a 1,2-dimethyl-n-propylene group, 2,2-dimethyl-n-propylene, a 1-ethyl-n-propylene group, a cyclopentylene group, a 1-methyl-cyclobutylene group, a 2-methyl-cyclobutylene group, a 3-methyl-cyclobutylene group, a 1,2-dimethyl-cyclopropylene group, a 2,3-dimethyl-cyclopropylene group, a 1-ethyl-cyclopropylene group, a 2-ethyl-cyclopropylene group, a n-hexylene group, a 1-methyl-n-pentylene group, a 2-methyl-n-pentylene group, a 3-methyl-n-pentylene group, a 4-methyl-n-pentylene group, a 1,1-dimethyl-n-butylene group, a 1,2-dimethyl-n-butylene group, a 1,3-dimethyl-n-butylene group, a 2,2-dimethyl-n-butylene group, a 2,3-dimethyl-n-butylene group, a 3,3-dimethyl-n-butylene group, a 1-ethyl-n-butylene group, a 2-ethyl-n-butylene group, a 1,1,2-trimethyl-n-propylene group, a 1,2,2-trimethyl-n-propylene group, a 1-ethyl-1-methyl-n-propylene group, a 1-ethyl-2-methyl-n-propylene group, a cyclohexylene group, a 1-methyl-cyclopentylene group, a 2-methyl-cyclopentylene group, a 3-methyl-cyclopentylene group, a 1-ethyl-cyclobutylene group, a 2-ethyl-cyclobutylene group, a 3-ethyl-cyclobutylene group, a 1,2-dimethyl-cyclobutylene group, a 1,3-dimethyl-cyclobutylene group, a 2,2-dimethyl-cyclobutylene group, a 2,3-dimethyl-cyclobutylene group, a 2,4-dimethyl-cyclobutylene group, a 3,3-dimethyl-cyclobutylene group, a 1-n-propyl-cyclopropylene group, a 2-n-propyl-cyclopropylene group, a 1-isopropyl-cyclopropylene group, a 2-isopropyl-cyclopropylene group, a 1,2,2-trimethyl-cyclopropylene group, a 1,2,3-trimethyl-cyclopropylene group, a 2,2,3-trimethyl-cyclopropylene group, a 1-ethyl-2-methyl-cyclopropylene group, a 2-ethyl-1-methyl-cyclopropylene group, a 2-ethyl-2-methyl-cyclopropylene group, a 2-ethyl-3-methyl-cyclopropylene group, a n-heptylene group, a n-octylene group, a n-nonylene group, and a n-decanylene group.

An example of the alkyl group having 1 to 10 carbon atoms that is substituted or interrupted by a heteroatom in R¹ is an alkoxy group having 1 to 10 carbon atoms.

Examples of the alkoxy group having 1 to 10 carbon atoms include a methoxy group, an ethoxy group, a n-propoxy group, an i-propoxy group, a n-butoxy group, an i-butoxy group, a s-butoxy group, a t-butoxy group, a n-pentoxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, a n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2,-trimethyl-n-propoxy group, a 1-ethyl-1-methyl-n-propoxy group, a 1-ethyl-2-methyl-n-propoxy group, a n-heptyloxy group, a n-octyloxy group, and a n-nonyloxy group.

A is, for example, a group represented by Formula (A) below. 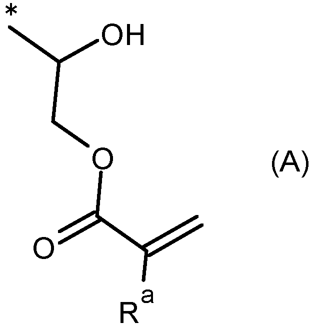 (In Formula (A), R^{a} is a hydrogen atom or a methyl group. * represents a bond.)

The unit structure represented by Formula (1-1) may be one kind or a combination of two or more kinds. For example, a copolymer having a plurality of unit structures in which Ar is the same kind may be used, and for example, a copolymer having a plurality of unit structures in which Ar is different in kind, such as a copolymer having a unit structure in which Ar includes a benzene ring and a unit structure in which Ar includes a naphthalene ring, is not excluded from the technical scope of the present application.

The phrase "may be interrupted" means that in the case of an alkylene group having 2 to 10 carbon atoms, any carbon-carbon atom bond in the alkylene group is interrupted by a heteroatom (that is, an ether bond in the case of oxygen, and a sulfide bond in the case of sulfur), an ester bond, or an amide bond, and in the case of a carbon atom number of 1 (that is, a methylene group), either one of the carbons of the methylene group has a heteroatom (that is, an ether bond in the case of oxygen, and a sulfide bond in the case of sulfur), an ester bond, or an amide bond.

When n2 = 1, T¹ represents a single bond, or an alkylene group having 1 to 10 carbon atoms that may be interrupted by an ether bond, an ester bond, or an amide bond, and T¹ is preferably a combination of an ether bond and a methylene group, a combination of an ester bond and a methylene group, or a combination of an amide bond and a methylene group.

The alkyl group having 1 to 10 carbon atoms that may be substituted with a heteroatom means that one or more hydrogen atoms of the alkyl group having 1 to 10 carbon atoms are substituted with a heteroatom(s) (preferably a halogeno group).

L¹ represents a single bond or an alkylene group having 1 to 10 carbon atoms and is preferably represented by Formula (1-2) below.

-CR²R³- (1-2)

It is preferably represented by (in Formula (1-2), R² and R³ each independently represent a hydrogen atom, a methyl group, an ethyl group, a n-propyl group, an i-propyl group, a cyclopropyl group, a n-butyl group, an i-butyl group, a s-butyl group, a t-butyl group, or a cyclobutyl group, and R² and R³ may be bonded to each other to form a ring having 3 to 6 carbon atoms). Among them, both R² and R³ are hydrogen atoms (that is, -(CR²R³)- is a methylene group)

The halogeno group refers to halogen-X (F, Cl, Br, or I) substituted with hydrogen.

The polymer having a structural unit represented by Formula (1-1) is obtained, for example, by reacting a polymer having a unit structure represented by Formula (1-1') below with (meth)acrylic acid. 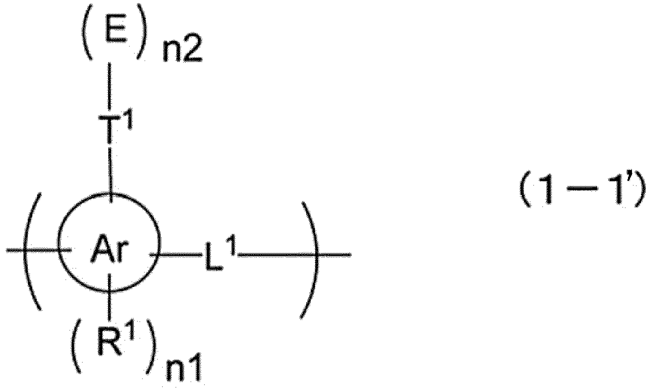 (In Formula (1-1'), Ar, R¹, n1, L¹, n2, and T¹ have the same meanings as Ar, R¹, n1, L¹, n2, and T¹ in Formula (1-1), respectively. E is a group having an epoxy group.)

The polymer having a structural unit represented by Formula (1-1') is not particularly limited as long as it satisfies, for example, the unit structure of Formula (1-1'). It may be manufactured by a known method. Commercially available products may be used. Examples of the commercially available products include heat-resistant epoxy novolac resin EOCN (registered trademark) series (manufactured by Nippon Kayaku Co., Ltd., epoxy novolac resin D.E.N (registered trademark) series (manufactured by Dow Chemical Japan Ltd.).

The weight average molecular weight of the polymer having a structural unit represented by Formula (1-1') is 100 or more, 500 to 200,000, 600 to 50,000, or 700 to 10,000.

Examples of the polymer having a structural unit represented by Formula (1-1') include polymers having the following unit structures.

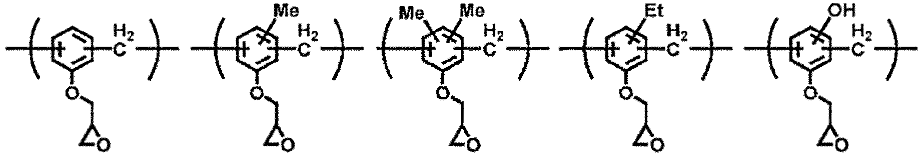

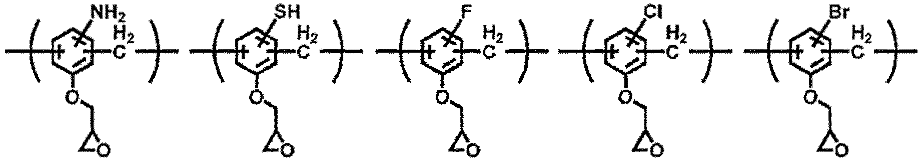

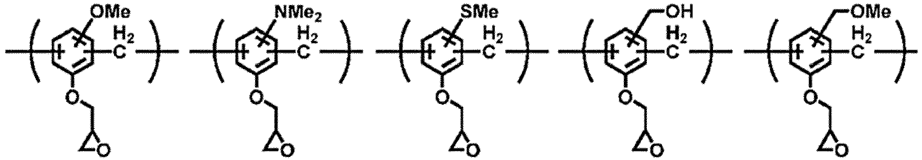

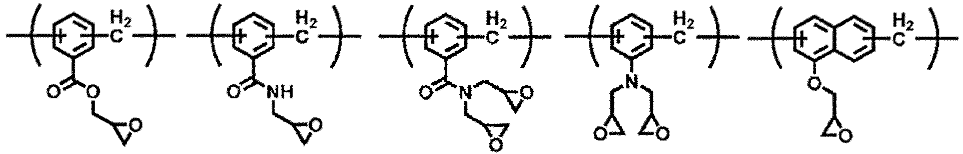

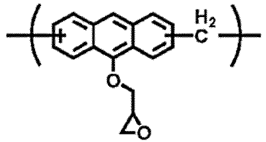

In the formula, Me represents a methyl group, and Et represents an ethyl group.

The weight average molecular weight of the polymer or compound having a crosslinkable group is not particularly limited but is preferably 2,000 to 50,000, more preferably 2,500 to 25,000, particularly preferably 3,000 to 9,000.

The weight average molecular weight can be measured by gel permeation chromatography (GPC).

The content of the polymer or compound having a crosslinkable group in the protective-film forming composition is not particularly limited but is preferably 1 mass% to 30 mass%, more preferably 5 mass% to 25 mass%, particularly preferably 10 mass% to 20 mass%.

The content of the polymer or compound having a crosslinkable group in the protective-film forming composition is not particularly limited but is preferably 70 mass% to 99 mass%, more preferably 80 mass% to 97 mass%, particularly preferably 85 mass% to 95 mass% with respect to the film constituents. The film constituents are components excluding volatile components (solvent) from the protective-film forming composition.

### <Other Components>

Furthermore, the protective-film forming composition can include, as necessary, a radical polymerization initiator (such as a photopolymerization initiator), an acid (catalyst), a thermal acid generator, a photoacid generator, a base (catalyst), a thermal base generator, a photobase generator, a polymerization inhibitor, a crosslinking agent (such as a polyfunctional acrylic), an adhesion improver, an adhesion aid (silane coupling agent), a surfactant, an antifoaming agent, a rheology modifier, a pigment, a dye, a storage stabilizer, a dissolution accelerator such as a polyhydric phenol and a polyvalent carboxylic acid, a sensitizer, and the like.

The radical polymerization initiator may be any initiator as long as it can release a substance that initiates radical polymerization through light irradiation and/or heating. Examples of the photoradical polymerization initiator include benzophenone derivatives, imidazole derivatives, bisimidazole derivatives, N-arylglycine derivatives, organic azide compounds, titanocene compounds, aluminate complexes, organic peroxides, N-alkoxypyridinium salts, and thioxanthone derivatives. More specific examples thereof include benzophenone, 1,3-di(tert-butyldioxycarbonyl)benzophenone, 3,3',4,4'-tetrakis(tert-butyldioxycarbonyl)benzophenone, 3-phenyl-5-isoxazolone, 2-mercaptobenzimidazole, bis(2,4,5-triphenyl)imidazole, 2,2-dimethoxy-1,2-diphenylethan-1-one, 1-hydroxycyclohexyl phenyl ketone, 2-benzyl-2-dimethylamino-1-(4-morpholinophenyl)-butan-1-one, bis(η⁵-2,4-cyclopentadien-1-yl)-bis(2,6-difluoro-3-(1H-pyrrol-1-yl)-phenyl)titanium, but are not limited thereto.

As the photoradical polymerization initiator, a commercially available product can also be used, and examples thereof include IRGACURE (registered trademark) 651, 184, 369, and 784 manufactured by BASF Japan Ltd. Commercially available products other than the above can also be used, and specific examples include IRGACURE (registered trademark) 500, 907, 379, 819, 127, 500, 754, 250, 1800, 1870, and OXE01 and DAROCUR (registered trademark) TPO and 1173 manufactured by BASF Japan Ltd.; Speedcure (registered trademark) MBB, PBZ, ITX, CTX, and EDB manufactured by Lambson Ltd.; Esacure (registered trademark) ONE, KIP150, and KTO46 manufactured by Lamberti S.p.A.; and KAYACURE (registered trademark) DETX-S, CTX, BMS, and DMBI manufactured by Nippon Kayaku Co., Ltd.

Examples of the thermal radical polymerization initiator include peroxides such as acetyl peroxide, benzoyl peroxide, methyl ethyl ketone peroxide, cyclohexanone peroxide, hydrogen peroxide, tert-butyl hydroperoxide, cumene hydroperoxide, di-tert-butyl peroxide, dicumyl peroxide, dilauroyl peroxide, tert-butyl peroxyacetate, tert-butyl peroxypivalate, and tert-butylperoxy-2-ethylhexanoate; azo-based compounds such as 2,2'-azobisisobutyronitrile, 2,2'-azobis(2,4-dimethylvaleronitrile), (1-phenylethyl)azodiphenylmethane, 2,2'-azobis(4-methoxy-2,4-dimethylvaleronitrile), dimethyl-2,2'-azobisisobutyrate, 2,2'-azobis(2-methylbutyronitrile), 1,1'-azobis(1-cyclohexanecarbonitrile), 2-(carbamoylazo)isobutyronitrile, 2,2'-azobis(2,4,4-trimethylpentane), 2-phenylazo-2,4-dimethyl-4-methoxyvaleronitrile, and 2,2'-azobis(2-methylpropane); and persulfates such as ammonium persulfate, sodium persulfate, and potassium persulfate, but are not limited thereto.

Examples of the commercially available thermal radical polymerization initiator include PEROYL (registered trademark) IB, NPP, IPP, SBP, TCP, OPP, SA, 355, and L, PERBUTYL (registered trademark) ND, NHP, MA, PV, 355, A, C, D, E, L, I, O, P, and Z, PERHEXYL (registered trademark) ND, PV, D, I, O, and Z, PEROCTA (registered trademark) ND, NYPER (registered trademark) PMB, BMT, and BW, PERTETRA (registered trademark) A, PERHEXA (registered trademark) MC, TMH, HC, 250, 25B, C, 25Z, 22, and V, PEROCTA (registered trademark) O, PERCUMYL (registered trademark) ND and D, PERMENTA (registered trademark) H, and NOFMER (registered trademark) BC manufactured by NOF Corporation; V-70, V-65, V-59, V-40, V-30, VA-044, VA-046B, VA-061, V-50, VA-057, VA-086, VF-096, VAm-110, V-601, and V-501 manufactured by Wako Pure Chemical Industries, Ltd.; IRGACURE (registered trademark) 184, 369, 651, 500, 819, 907, 784, 2959, CGI1700, CGI1750, CGI1850, and CG24-61, DAROCUR (registered trademark) 1116 and 1173, and LUCIRIN (registered trademark) TPO manufactured by BASF Japan Ltd.; UVECRYL (registered trademark) P36 manufactured by Cytec Surface Specialties S.A.; and Esacure (registered trademark) KIP150, KIP65LT, KIP100F, KT37, KT55, KTO46, and KIP75/B manufactured by Lamberti S.p.A., but are not limited thereto.

Only one kind of radical polymerization initiator may be used, or two or more kinds thereof may be used in combination. The content of the radical polymerization initiator is preferably 1 part by mass or more, 2 parts by mass or more, or 3 parts by mass or more and 50 parts by mass or less, 20 parts by mass or less, or 10 parts by mass or less with respect to 100 parts by mass of the polymer or compound having a crosslinkable group.

As the polymerization inhibitor (antioxidant), a hindered phenol compound may be used, and specific examples include 2,6-diisobutylphenol, 3,5-di-t-butylphenol, 3,5-dit-butylcresol, hydroquinone, hydroquinone monomethyl ether, aluminum N-nitroso-N-phenylhydroxylamine, pyrogallol, t-butylcatechol, 4-methoxy-1-naphthol, 2,6-di-t-butyl-4-methylphenol, 2,5-di-t-butyl-hydroquinone, octadecyl-3-(3,5-di-t-butyl-4-hydroxyphenyl)propionate, isooctyl-3-(3,5-di-t-butyl-4-hydroxyphenyl)propionate, 4,4'-methylenebis(2,6-di-t-butylphenol), 4,4'-thio-bis(3-methyl-6-t-butylphenol), 4,4'-butylidene-bis(3-methyl-6-t-butylphenol), triethylene glycol-bis[3-(3-t-butyl-5-methyl-4-hydroxyphenyl)propionate], 1,6-hexanediol-bis[3-(3,5-dit-butyl-4-hydroxyphenyl)propionate], 2,2-thio-diethylenebis[3-(3,5-di-t-butyl-4-hydroxyphenyl)propionate], N,N'-hexamethylenebis(3,5-di-t-butyl-4-hydroxy-hydrocinnamamide), 2,2'-methylene-bis(4-methyl-6-t-butylphenol), 2,2'-methylene-bis(4-ethyl-6-t-butylphenol), pentaerythrityl-tetrakis[3-(3,5-di-t-butyl-4-hydroxyphenyl)propionate], tris-(3,5-di-t-butyl-4-hydroxybenzyl)-isocyanurate, 1,3,5-trimethyl-2,4,6-tris(3,5-di-t-butyl-4-hydroxybenzyl)benzene, 1,3,5-tris(3-hydroxy-2,6-dimethyl-4-isopropylbenzyl)-1,3,5-triazine-2,4,6-(1H,3H,5H)-trione, 1,3,5-tris(4-t-butyl-3-hydroxy-2,6-dimethylbenzyl)-1,3,5-triazine-2,4,6-(1H,3H,5H)-trione, 1,3,5-tris(4-s-butyl-3-hydroxy-2,6-dimethylbenzyl)-1,3,5-triazine-2,4,6-(1H,3H,5H)-trione, 1,3,5-tris[4-(1-ethylpropyl)-3-hydroxy-2,6-dimethylbenzyl]-1,3,5-triazine-2,4,6-(1H,3H,5H)-trione, 1,3,5-tris[4-triethylmethyl-3-hydroxy-2,6-dimethylbenzyl]-1,3,5-triazine-2,4,6-(1H,3H,5H)-trione, 1,3,5-tris(3-hydroxy-2,6-dimethyl-4-phenylbenzyl)-1,3,5-triazine-2,4,6-(1H,3H,5H)-trione, 1,3,5-tris(4-t-butyl-3-hydroxy-2,5,6-trimethylbenzyl)-1,3,5-triazine-2,4,6-(1H,3H,5H)-trione, 1,3,5-tris(4-t-butyl-5-ethyl-3-hydroxy-2,6-dimethylbenzyl)-1,3,5-triazine-2,4,6-(1H,3H,5H)-trione, 1,3,5-tris(4-t-butyl-6-ethyl-3-hydroxy-2-methylbenzyl)-1,3,5-triazine-2,4,6-(1H,3H,5H)-trione, 1,3,5-tris(4-t-butyl-6-ethyl-3-hydroxy-2,5-dimethylbenzyl)-1,3,5-triazine-2,4,6-(1H,3H,5H)-trione, 1,3,5-tris(4-t-butyl-5,6-diethyl-3-hydroxy-2-methylbenzyl)-1,3,5-triazine-2,4,6-(1H,3H,5H)-trione, 1,3,5-tris(4-t-butyl-3-hydroxy-2-methylbenzyl)-1,3,5-triazine-2,4,6-(1H,3H,5H)-trione, 1,3,5-tris(4-t-butyl-3-hydroxy-2,5-dimethylbenzyl)-1,3,5-triazine-2,4,6-(1H,3H,5H)-trione, and 1,3,5-tris(4-t-butyl-5-ethyl-3-hydroxy-2-methylbenzyl)-1,3,5-triazine-2,4,6-(1H,3H,5H)-trione.

Among the hindered phenol compounds, 1,3,5-tris(4-t-butyl-3-hydroxy-2,6-dimethylbenzyl)-1,3,5-triazine-2,4,6-(1H,3H,5H)-trione is preferable.

As the polymerization inhibitor, a commercially available product may be used, and specific examples thereof include Irganox-3114 (manufactured by BASF Japan Ltd.).

Only one kind of polymerization inhibitor may be used, or two or more kinds thereof may be used in combination. The content of the polymerization inhibitor is preferably 0.01 to 1 parts by mass, more preferably 0.01 to 0.5 parts by mass with respect to 100 parts by mass of the polymer or compound having a crosslinkable group.

Examples of the surfactant include polyoxyethylene alkyl ether compounds such as polyoxyethylene lauryl ether, polyoxyethylene stearyl ether, and polyoxyethylene oleyl ether; polyoxyethylene alkyl allyl ether compounds such as polyoxyethylene octyl phenol ether and polyoxyethylene nonyl phenol ether; polyoxyethylene-polyoxypropylene block copolymer compounds; sorbitan fatty acid ester compounds such as sorbitan monolaurate, sorbitan monopalmitate, sorbitan monostearate, sorbitan trioleate, and sorbitan tristearate; and polyoxyethylene sorbitan fatty acid ester compounds such as polyoxyethylene sorbitan monolaurate, polyoxyethylene sorbitan monopalmitate, polyoxyethylene sorbitan monostearate, and polyoxyethylene sorbitan tristearate. In addition, examples include fluorine-based surfactants such as EFTOP (trade name) EF301, EF303, and EF352 (manufactured by TOCHEM PRODUCTS CORPORATION), MEGAFACE (trade name) F171, F173, R-08, and R-30 (manufactured by Dainippon Ink and Chemicals, Inc.), Fluorad FC430 and FC431 (manufactured by Sumitomo 3M Limited), and AsahiGuard (trade name) AG710 and Surflon (trade name) S-382, SC101, SC102, SC103, SC104, SC105, and SC106 (manufactured by Asahi Glass Co., Ltd.), and organosiloxane polymer KP341 (manufactured by Shin-Etsu Chemical Co., Ltd.).

Only one kind of surfactant may be used, or two or more kinds thereof may be used in combination. The content of the surfactant is preferably 0.1 parts by mass or more or 0.5 parts by mass or more and 5 parts by mass or less or 2 parts by mass or less with respect to 100 parts by mass of the polymer or compound having a crosslinkable group.

As the acid catalyst, an acidic compound, a basic compound, or various compounds that generate an acid or a base through application of heat or light can be used.

As the acidic compound, a sulfonic acid compound or a carboxylic acid compound can be used.

Examples of the sulfonic acid compound or the carboxylic acid compound include p-toluenesulfonic acid, trifluoromethanesulfonic acid, pyridinium trifluoromethanesulfonate (= pyridinium trifluoromethanesulfonic acid), pyridinium-p-toluenesulfonate, pyridinium-4-hydroxybenzenesulfonate, salicylic acid, camphorsulfonic acid, 5-sulfosalicylic acid, 4-chlorobenzenesulfonic acid, 4-phenolsulfonic acid, pyridinium-4-phenolsulfonate, benzenesulfonic acid, 1-naphthalenesulfonic acid, 4-nitrobenzenesulfonic acid, citric acid, benzoic acid, and hydroxybenzoic acid.

As the basic compound, an amine compound or an ammonium hydroxide compound can be used, and as the compound that generates a base through application of heat, urea can be used.

Examples of the amine compound include tertiary amines such as triethanolamine, tributanolamine, trimethylamine, triethylamine, tri-n-propylamine, triisopropylamine, tri-n-butylamine, tri-tert-butylamine, tri-n-octylamine, triisopropanolamine, phenyldiethanolamine, stearyldiethanolamine, and diazabicyclooctane, and aromatic amines such as pyridine and 4-dimethylaminopyridine. Examples of the amine compounds include primary amines such as benzylamine and n-butylamine, and secondary amines such as diethylamine and di-n-butylamine.

Examples of the ammonium hydroxide compound include tetramethylammonium hydroxide, tetraethylammonium hydroxide, tetrapropylammonium hydroxide, tetrabutylammonium hydroxide, benzyltrimethylammonium hydroxide, benzyltriethylammonium hydroxide, cetyltrimethylammonium hydroxide, phenyltrimethylammonium hydroxide, and phenyltriethylammonium hydroxide.

As the acid generator, both a thermal acid generator and a photoacid generator can be used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium-p-hydroxybenzenesulfonic acid (pyridinium p-phenolsulfonic acid salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid.

Examples of the commercially available product include K-PURE [registered trademark] CXC-1612, CXC-1614, TAG-2172, TAG-2179, TAG-2678, and TAG2689 (the above products are manufactured by King Industries, Inc.), and SI-45, SI-60, SI-80, SI-100, SI-110, and SI-150 (the above products are manufactured by Sanshin Chemical Industry Co., Ltd.).

Examples of the photoacid generator include a sulfonium salt, an iodonium salt, sulfonyldiazomethane, N-sulfonyloximide, a benzoin sulfonate type photoacid generator, a pyrogallol trisulfonate type photoacid generator, a sulfone type photoacid generator, a glyoxime derivative type photoacid generator, an oxime-O-sulfonate type acid generator, and a bisoxime sulfonate type acid generator. Examples thereof include bis(4-tert-butylphenyl)iodonium trifluoromethanesulfonate, triphenylsulfonium trifluoromethanesulfonate, phenyl-bis(trichloromethyl)-s-triazine, benzoin tosylate, and N-hydroxysuccinimide trifluoromethanesulfonate.

Examples of the thermal base generator include carbamates such as 1-methyl-1-(4-biphenylyl) ethylcarbamate and 2-cyano-1,1-dimethylethylcarbamate; ureas such as urea and N,N-dimethyl-N'-methylurea; guanidines such as guanidine trichloroacetate, guanidine phenylsulfonylacetate, and guanidine phenylpropiolate; dihydropyridines such as 1,4-dihydronicotinamide; dimethylpiperidines such as N-(isopropoxycarbonyl)-2,6-dimethylpiperidine, N-(tert-butoxycarbonyl)-2,6-dimethylpiperidine, and N-(benzyloxycarbonyl)-2,6-dimethylpiperidine; quaternized ammonium salts such as tetramethylammonium phenylsulfonylacetate and tetramethylammonium phenylpropiolate; and dicyandiamide. In addition, U-CAT (registered trademark) SA810, SA831, SA841, and SA851 [the above products are manufactured by San-Apro Ltd.], which are salts of 1,8-diazabicyclo[5.4.0]undec-7-ene (DBU), and the like can be mentioned.

Examples of the photobase generator include alkylamine-based photobase generators such as 9-anthrylmethyl=N,N-diethylcarbamate; cycloalkylamine-based photobase generators such as 9-anthryl=N,N-dicyclohexylcarbamate, 1-(9,10-anthraquinon-2-yl)ethyl=N,N-dicyclohexylcarbamate, dicyclohexylammonium=2-(3-benzoylphenyl)propionate, 9-anthryl=N-cyclohexylcarbamate, 1-(9,10-anthraquinon-2-yl)ethyl=N-cyclohexylcarbamate, cyclohexylammonium=2-(3-benzoylphenyl)propionate, and (E)-N-cyclohexyl-3-(2-hydroxyphenyl)acrylamide; piperidine-based photobase generators such as 9-anthrylmethyl=piperidine-1-carboxylate, (E)-1-piperidino-3-(2-hydroxyphenyl)-2-propen-1-one, (2-nitrophenyl)methyl=4-hydroxypiperidine-1-carboxylate, and (2-nitrophenyl)methyl=4-(methacryloyloxy)piperidine-1-carboxylate; guanidine-based photobase generators such as guanidinium=2-(3-benzoylphenyl) propionate, 1,2-diisopropyl-3-(bis(dimethylamino)methylene)guanidinium=2-(3-benzoylphenyl)propionate, 1,2-dicyclohexyl-4,4,5,5-tetramethylbiguanidium=n-butyltriphenylborate, and 1,5,7-triazabicyclo[4.4.0]deca-5-enium=2-(9-oxoxanthen-2-yl)propionate; and imidazole-based photobase generators such as 1-(9,10-anthraquinon-2-yl)ethyl=imidazole-1-carboxylate.

The above components can be used singly or in combination of two or more thereof, and in that case, they are usually used in a blending amount of 10 mass% or less, preferably 3 mass% or less in the solid content of the protective-film forming composition.

The method for preparing the protective-film forming composition is not particularly limited. That is, a polymer or compound having a crosslinkable group, a solvent, and other components may be mixed in an arbitrary ratio and in an arbitrary order to form a uniform solution. The protective-film forming composition thus prepared in a solution state is preferably used after being filtered using a filter or the like having a pore size of about 0.2 µm.

As described later, in order to prepare a protective film having a film thickness of about 300 nm by a spin coating method, the protective-film forming composition preferably has a viscosity of about 100 cps or less, more preferably 50 cps or less, particularly preferably 10 cps or less at 25°C. In the present invention, the viscosity is a value measured at 25°C with an E-type viscometer.

The protective-film forming composition is preferably photosensitive. For example, it may be a negative-type solvent developing type. In the case of a photosensitive protective-film forming composition, after the photosensitive protective-film forming composition (negative type) is applied to a front surface end portion, a bevel portion, and optionally a back surface end portion of the substrate, a portion where a film is to be cured is exposed and developed, so that the bevel portion can be accurately covered with the protective film. Due to the photosensitivity, there are advantages that the film thickness of the protective film at the wafer end can be easily controlled, the inner humps can be removed, the edge shape can be improved, and the deviation of the center position at the time of rotational coating can be corrected.

The protective-film forming composition may be a composition containing a compound (E) containing at least one partial structure selected from partial structures (I) represented by Formulas (1-1) to (1-7) below, which is described in WO 2018/190380 A1.

The compound (E) is a polymer or compound having a crosslinkable group. 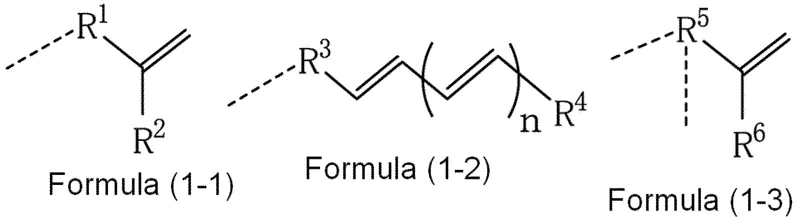 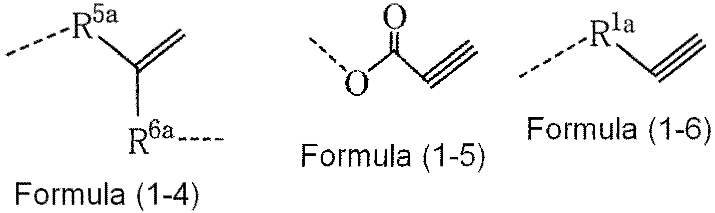 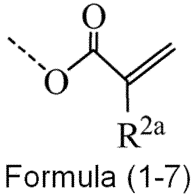
(In the formulas, R¹, R^{1a}, R³, R^{5a}, and R^{6a} each independently represent a divalent group consisting of an alkylene group having 1 to 10 carbon atoms, an arylene group having 6 to 40 carbon atoms (the alkylene group and the arylene group may be optionally substituted with one or two or more amide groups or amino groups), an oxygen atom, a carbonyl group, a sulfur atom, -C(O)-NR^{a}-, -NR^{b}-, or a combination thereof,
R⁵ each independently represents a trivalent group consisting of a nitrogen atom or a combination of a nitrogen atom and at least one or more groups selected from the group consisting of an alkylene group having 1 to 10 carbon atoms, an arylene group having 6 to 40 carbon atoms (the alkylene group and the arylene group may be optionally substituted with one or two or more amide groups or amino groups), an oxygen atom, a carbonyl group, a sulfur atom, - C(O)-NR^{a}-, and -NR^{b}-,
R², R^{2a}, R⁴, and R⁶ each independently represent a monovalent group consisting of a hydrogen atom or an alkyl group having 1 to 10 carbon atoms, or a combination of a hydrogen atom and at least one or more groups selected from the group consisting of an alkylene group having 1 to 10 carbon atoms, an oxygen atom, a carbonyl group, -C(O)-NR^{a}-, and -NR^{b}-,
R^{a} represents a hydrogen atom or an alkyl group having 1 to 10 carbon atoms,
R^{b} represents a hydrogen atom, an alkyl group having 1 to 10 carbon atoms, or an alkylcarbonyl group having 1 to 10 carbon atoms,
n represents the number of repeating units of 1 to 10, and
a dotted line represents a chemical bond with an adjacent atom.)

The entire disclosure of WO 2018/190380 A1 is incorporated herein by reference.

The protective-film forming composition may contain a polysiloxane. The polysiloxane may be a modified polysiloxane in which a part of silanol groups is modified, such as a polysiloxane modified product in which a part of silanol groups is alcohol-modified or acetal-protected.

In addition, the polysiloxane may be, as an example, a hydrolysis condensate of a hydrolyzable silane, or may be a modified product (hereinafter may be referred to as a "modified product of a hydrolysis condensate") in which at least a part of silanol groups of the hydrolysis condensate is alcohol-modified or acetal-protected. The hydrolyzable silane related to the hydrolysis condensate can contain one or two or more hydrolyzable silanes.

The polysiloxane can have any of cage-shaped, ladder-shaped, linear, and branched main chains. Further, commercially available polysiloxanes can be used.

In the present invention, the "hydrolysis condensate" of the hydrolyzable silane, that is, the product of the hydrolysis condensation includes not only a polyorganosiloxane polymer that is a condensation product in which the condensation is completely completed but also a polyorganosiloxane polymer that is a partial hydrolysis condensation product in which the condensation is not completely completed. Such a partial hydrolysis condensate is also a polymer obtained by hydrolysis and condensation of a hydrolyzable silane similarly to a condensate in which condensation is completely completed. However, the reaction of the polymer is partially stopped at the stage of hydrolysis, and the polymer is not condensed, so that Si-OH groups remain.

Examples of the polysiloxane of the present invention include a hydrolysis condensate of a hydrolyzable silane containing at least one hydrolyzable silane represented by Formula (1) below or a modified product thereof.
<<Formula (1)>>

R¹ₐSi(R²)₄₋ₐ (1)

In Formula (1), R¹ is a group bonded to a silicon atom and independently of one another represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group, an optionally substituted alkoxyaralkyl group, or an optionally substituted alkenyl group, or represents an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof.
R² is a group or atom bonded to a silicon atom, and independently of one another represents an alkoxy group, an aralkyloxy group, an acyloxy group, or a halogen atom.
a represents an integer of 0 to 3.

Specific examples of each of the groups and atoms in R¹ in Formula (1) and suitable carbon numbers thereof include the groups and carbon numbers described above for R³ in Formulas (A-1) and (A-2).

Specific examples of each of the groups and atoms in R² in Formula (1) and suitable carbon numbers thereof include the groups and atoms and carbon numbers described above for X in Formulas (A-1) and (A-2).

### <<<Specific Examples of Hydrolyzable Silane Represented by Formula (1)>>>

Specific examples of the hydrolyzable silane represented by Formula (1) include tetramethoxysilane, tetrachlorosilane, tetraacetoxysilane, tetraethoxysilane, tetra-n-propoxysilane, tetra-i-propoxysilane, tetra-n-butoxysilane, methyltrimethoxysilane, methyltrichlorosilane, methyltriacetoxysilane, methyltriethoxysilane, methyltripropoxysilane, methyltributoxysilane, methyltriamyloxysilane, methyltriphenoxysilane, methyltribenzyloxysilane, methyltriphenethyloxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltrimethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylethyldimethoxysilane, α-glycidoxypropylmethyldimethoxysilane, α-glycidoxypropylmethyldiethoxysilane, β-glycidoxypropylmethyldimethoxysilane, β-glycidoxypropylethyldimethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldiphenoxysilane, γ-glycidoxypropylethyldimethoxysilane, γ-glycidoxypropylethyldiethoxysilane, γ-glycidoxypropylvinyldimethoxysilane, γ-glycidoxypropylvinyldiethoxysilane, ethyltrimethoxysilane, ethyltriethoxysilane, vinyltrimethoxysilane, vinyltriethoxysilane, vinyltrichlorosilane, vinyltriacetoxysilane, methylvinyldimethoxysilane, methylvinyldiethoxysilane, methylvinyldichlorosilane, methylvinyldiacetoxysilane, dimethylvinylmethoxysilane, dimethylvinylethoxysilane, dimethylvinylchlorosilane, dimethylvinylacetoxysilane, divinyldimethoxysilane, divinyldiethoxysilane, divinyldichlorosilane, divinyldiacetoxysilane, γ-glycidoxypropylvinyldimethoxysilane, γ-glycidoxypropylvinyldiethoxysilane, allyltrimethoxysilane, allyltriethoxysilane, allyltrichlorosilane, allyltriacetoxysilane, allylmethyldimethoxysilane, allylmethyldiethoxysilane, allylmethyldichlorosilane, allylmethyldiacetoxysilane, allyldimethylmethoxysilane, allyldimethylethoxysilane, allyldimethylchlorosilane, allyldimethylacetoxysilane, diallyldimethoxysilane, diallyldiethoxysilane, diallyldichlorosilane, diallyldiacetoxysilane, 3-allylaminopropyltrimethoxysilane, 3-allylaminopropyltriethoxysilane, p-styryltrimethoxysilane, phenyltrimethoxysilane, phenyltriethoxysilane, phenyltrichlorosilane, phenyltriacetoxysilane, phenylmethyldimethoxysilane, phenylmethyldiethoxysilane, phenylmethyldichlorosilane, phenylmethyldiacetoxysilane, phenyldimethylmethoxysilane, phenyldimethylethoxysilane, phenyldimethylchlorosilane, phenyldimethylacetoxysilane, diphenylmethylmethoxysilane, diphenylmethylethoxysilane, diphenylmethylchlorosilane, diphenylmethylacetoxysilane, diphenyldimethoxysilane, diphenyldiethoxysilane, diphenyldichlorosilane, diphenyldiacetoxysilane, triphenylmethoxysilane, triphenylethoxysilane, triphenylacetoxysilane, triphenylchlorosilane, 3-phenylaminopropyltrimethoxysilane, 3-phenylaminopropyltriethoxysilane, dimethoxymethyl-3-(3-phenoxypropylthiopropyl)silane, triethoxy((2-methoxy-4-(methoxymethyl) phenoxy) methyl) silane, benzyltrimethoxysilane, benzyltriethoxysilane, benzylmethyldimethoxysilane, benzylmethyldiethoxysilane, benzyldimethylmethoxysilane, benzyldimethylethoxysilane, benzyldimethylchlorosilane, phenethyltrimethoxysilane, phenethyltriethoxysilane, phenethyltrichlorosilane, phenethyltriacetoxysilane, phenethylmethyldimethoxysilane, phenethylmethyldiethoxysilane, phenethylmethyldichlorosilane, phenethylmethyldiacetoxysilane, methoxyphenyltrimethoxysilane, methoxyphenyltriethoxysilane, methoxyphenyltriacetoxysilane, methoxyphenyltrichlorosilane, methoxybenzyltrimethoxysilane, methoxybenzyltriethoxysilane, methoxybenzyltriacetoxysilane, methoxybenzyltrichlorosilane, methoxyphenethyltrimethoxysilane, methoxyphenethyltriethoxysilane, methoxyphenethyltriacetoxysilane, methoxyphenethyltrichlorosilane, ethoxyphenyltrimethoxysilane, ethoxyphenyltriethoxysilane, ethoxyphenyltriacetoxysilane, ethoxyphenyltrichlorosilane, ethoxybenzyltrimethoxysilane, ethoxybenzyltriethoxysilane, ethoxybenzyltriacetoxysilane, ethoxybenzyltrichlorosilane, i-propoxyphenyltrimethoxysilane, i-propoxyphenyltriethoxysilane, i-propoxyphenyltriacetoxysilane, i-propoxyphenyltrichlorosilane, i-propoxybenzyltrimethoxysilane, i-propoxybenzyltriethoxysilane, i-propoxybenzyltriacetoxysilane, i-propoxybenzyltrichlorosilane, t-butoxyphenyltrimethoxysilane, t-butoxyphenyltriethoxysilane, t-butoxyphenyltriacetoxysilane, t-butoxyphenyltrichlorosilane, t-butoxybenzyltrimethoxysilane, t-butoxybenzyltriethoxysilane, t-butoxybenzyltriacetoxysilane, t-butoxyxybenzyltrichlorosilane, methoxynaphthyltrimethoxysilane, methoxynaphthyltriethoxysilane, methoxynaphthyltriacetoxysilane, methoxynaphthyltrichlorosilane, ethoxynaphthyltrimethoxysilane, ethoxynaphthyltriethoxysilane, ethoxynaphthyltriacetoxysilane, ethoxynaphthyltrichlorosilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-mercaptopropyltrimethoxysilane, γ-mercaptopropyltriethoxysilane, β-cyanoethyltriethoxysilane, thiocyanatopropyltriethoxysilane, chloromethyltrimethoxysilane, chloromethyltriethoxysilane, triethoxysilylpropyldiallyl isocyanurate, bicyclo[2,2,1]heptenyltriethoxysilane, benzenesulfonylpropyltriethoxysilane, benzenesulfonamidopropyltriethoxysilane, dimethylaminopropyltrimethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptomethyldiethoxysilane, methylvinyldimethoxysilane, and methylvinyldiethoxysilane, but are not limited thereto.

The protective-film forming composition may be a composition described in JP 2016-003160 A containing:
(A) a polyfunctional epoxy (meth)acrylate compound,
(B) a polyfunctional thiol compound, and
(C) a radical polymerization initiator.

The polyfunctional epoxy (meth)acrylate compound (A) is a polymer or compound having a crosslinkable group.

The molecular weight of the component (A) may be 300 to 20,000.

The component (A) may be a bisphenol-type polyfunctional epoxy (meth)acrylate compound.

The component (B) may be liquid at 25°C.

A polymerization inhibitor (D) may further be contained.

The viscosity at 25°C may be 2,000 to 100,000 mPa·s.

The entire disclosure of JP 2016-003160 A is incorporated herein by reference.

The protective-film forming composition may be a film forming composition containing a photopolymerizable substance and a photopolymerization initiator described in WO 2009/104643 A1. The photopolymerizable substance is a polymer or compound having a crosslinkable group.

The photopolymerizable substance may be a compound having at least one cationically polymerizable reactive group, and the cationic polymerization initiator may be a photocationic polymerization initiator.

The photopolymerizable substance may be a compound having at least one radically polymerizable reactive group, and the photopolymerization initiator may be a photoradical polymerization initiator.

The photopolymerizable substance may be a sugar compound.

The sugar compound may be a monosaccharide or disaccharide compound.

The sugar compound may be represented by Formula (10): 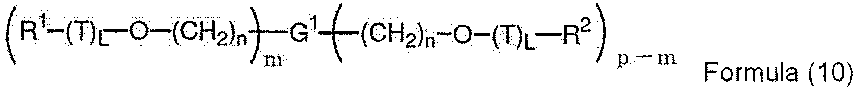 (where G¹ represents a sugar skeleton, T represents a divalent linking group, R¹ represents a vinyl group or a glycidyl group, R² represents a hydrogen atom or a hydroxy group, n and L each represent an integer of 0 or 1, p is an integer and is the total number of hydroxy groups of the sugar, and m is an integer satisfying 1 ≤ m ≤ (p - m)).

The photopolymerizable substance may be an alicyclic epoxy compound or an alicyclic oxetane compound.

The alicyclic epoxy compound may be a cycloalkylene oxide derivative.

The alicyclic epoxy compound may be represented by Formula (2) or Formula (3):

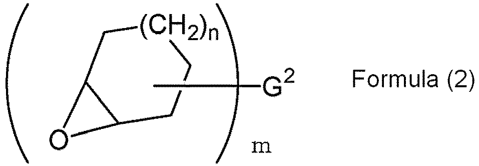

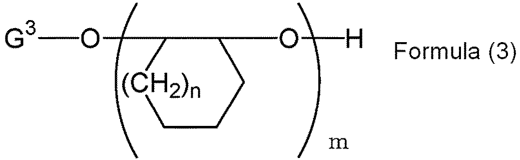

(G² represents a monovalent to pentavalent linking group having an alkylene group, a carbonyloxy group, a heterocyclic ring, an aromatic ring, or a combination thereof, G³ represents an organic group having an alkyl group, an alkylcarbonyl group, a heterocyclic ring, an aromatic ring, or a combination thereof, and n and m each represent an integer of 1 to 5).

The entire disclosure of WO 2009/104643 A1 is incorporated herein by reference.

### (Protective Film)

The protective film of the present invention is a cured product of a coating film formed of the protective-film forming composition of the present invention.

Examples of the method for forming the protective film include a step (X) in a method for manufacturing a semiconductor device described later.

For example, the protective film is a protective film for preventing metal contamination of a front surface end portion and a bevel portion of a wafer.

The lower limit of the thickness of the protective film is, for example, 1 nm, 3 nm, 5 nm, 10 nm, 30 nm, 50 nm, 80 nm, 100 nm, 200 nm, 500 nm, 800 nm, 1,000 nm, 1,500 nm, or 1,700 nm. The upper limit of the thickness of the protective film is, for example, 10,000 nm, 9,000 nm, 8,000 nm, 7,000 nm, 6,000 nm, 5,000 nm, 4,000 nm, 3,800 nm, 3,700 nm, 3,600 nm, 3,500 nm, 3,300 nm, 3,000 nm, 2,500 nm, 2,000 nm, 1,500 nm, 1,000 nm, 800 nm, 500 nm, or 300 nm.

The protective film is, for example, a protective film cured by being irradiated with light having a wavelength of 170 to 800 nm (such as 254 nm).

As the characteristics of the protective film covering the front surface end portion and the bevel portion of the substrate (wafer) for semiconductor manufacturing, in addition to the function of preventing metal contamination, it is desirable to satisfy dry etching resistance, phosphoric acid resistance, tetramethylammonium hydroxide (TMAH) resistance, HF removability, scratch resistance, good embeddability in a stepped substrate, a low sublimate amount, affinity to a hydrophobic substrate, leaving no crater foreign substance or the like on the side surface of the wafer (bevel portion), a good edge shape, a function of suppressing inner humps (a phenomenon in which a film forming composition remains in a bump shape immediately below an injection hole of a nozzle), and the like.

### (Method for Manufacturing Semiconductor Device)

The method for manufacturing a semiconductor device according to the present invention is a method for manufacturing a semiconductor device including:
a step (A) of forming a resist film on a semiconductor substrate;
a step (B) of forming a resist pattern by irradiating the resist film with light or an electron beam and subsequently performing development;
a step (C) of etching the semiconductor substrate using the resist pattern as a mask; and
a step (X) of forming a protective film on a front surface end portion, a bevel portion, and optionally a back surface end portion of a wafer for semiconductor manufacturing using the protective-film forming composition of the present invention.

Hereinafter, description will be made in order.

### <Step (A)>

In the step (A), a resist film is formed on a semiconductor substrate. The semiconductor substrate is a wafer used for manufacturing a semiconductor element or the like, and in addition to a generally used silicon wafer or germanium wafer, a compound semiconductor wafer formed by bonding two or more elements such as gallium arsenide, indium phosphide, gallium nitride, indium nitride, and aluminum nitride can be used. These are usually disk-shaped and have a size of, for example, 4, 6, 8, or 12 inches. Commercially available products may be used.

When a semiconductor substrate having an inorganic film formed on a surface thereof is used, the inorganic film is formed by, for example, an atomic layer deposition (ALD) method, a chemical vapor deposition (CVD) method, a reactive sputtering method, an ion plating method, a vacuum deposition method, or a spin coating method (spin on glass: SOG). Examples of the inorganic film include a polysilicon film, a silicon oxide film, a silicon nitride film, a borophosphosilicate glass (BPSG) film, a titanium nitride film, a titanium nitride oxide film, a tungsten film, a gallium nitride film, and a gallium arsenide film.

A resist underlayer film, a resist film, or the like having a predetermined thickness is formed on such a semiconductor substrate by an appropriate coating method using a spray, a spinner, a coater, or the like. In general, in the case of the spin coating method, each of the resist underlayer film forming composition, the resist film forming composition, and the like is supplied from above the central portion of the rotating disk-shaped substrate through a nozzle or the like. Usually, these films are baked using heating means such as a hot plate.

The photoresist used for forming the resist film is not particularly limited as long as it is sensitive to light used for exposure. In the present specification, an electron beam resist is also included in photoresists. Both a negative photoresist and a positive photoresist can be used. Examples of the photoresist include a positive photoresist containing a novolak resin and 1,2-naphthoquinonediazide sulfonic acid ester, a chemically amplified photoresist containing a binder having a group that is decomposed by an acid to increase the alkali dissolution rate and a photoacid generator, a chemically amplified photoresist containing a low molecular weight compound that is decomposed by an acid to increase the alkali dissolution rate of the photoresist, an alkalisoluble binder, and a photoacid generator, a chemically amplified photoresist containing a binder having a group that is decomposed by an acid to increase the alkali dissolution rate, a low molecular weight compound that is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by Sumitomo Chemical Industry Co., Ltd., and AR2772 and SEPR430 (trade names) manufactured by Shin-Etsu Chemical Co., Ltd. Further, examples thereof include fluorine-atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000). A negative photoresist is preferable.

The resist film forming composition used for forming the resist film can contain one or more kinds of metals. Examples of the form of the metal include a metal salt, a metal complex, and other metal-containing compounds in addition to a single-component metal. The metal species is not particularly limited, and examples thereof include tin, indium, antimony, bismuth, gallium, germanium, aluminum, zirconium, hafnium, cerium, lanthanum, and cesium.

The resist film forming composition used for forming the resist film may be a metal-containing resist.

The metal-containing resist is also called a metal oxide resist (MOR), and typical examples thereof include a tin oxide-based resist.

Examples of the metal oxide resist material include a coating composition containing a metal oxo-hydroxo network with organic ligands with metal carbon bonds and/or with metal carboxylate bonds described in JP 2019-113855 A.

An example of the metal-containing resist uses a peroxo ligand as a radiation-sensitive stabilizing ligand. Details of a peroxo-based metal oxo-hydroxo compound are described, for example, in patent literature described in paragraph [0011] of JP 2019-532489 A. Examples of the patent literatures include US 9,176,377 B2, US 2013/0224652 A1, US 9,310,684 B2, US 2016/0116839 A1, and US 15/291738 A.

The baking conditions of the resist film are appropriately selected from a baking temperature of 70°C to 400°C and a baking time of 0.3 minutes to 60 minutes. A baking temperature of 80°C to 350°C and a baking time of 0.5 minutes to 30 minutes are preferable, and a baking temperature of 90°C to 300°C and a baking time of 0.8 minutes to 10 minutes are more preferable.

The lower limit of the average thickness of the resist film is preferably 1 nm, more preferably 3 nm, 5 nm, or 10 nm. The upper limit of the average thickness of the resist film is 5,000 nm, 3,000 nm, 2,000 nm, preferably 1,000 nm, more preferably 200 nm, more preferably 50 nm.

### <Step (X) of Forming Protective Film>

The step (X) of forming a protective film from the protective-film forming composition of the present invention on the front surface end portion, the bevel portion, and optionally the back surface end portion of the wafer for semiconductor manufacturing is performed at an arbitrary time point. In the step (X), preferably, the protective-film forming composition is applied, and exposure on a predetermined region and development are performed. The step (X) may be performed before the step (A), may be performed between the step (A) and the step (B), or may be performed after the step (B) or the step (C).

In the present specification, a surface of the substrate on which a device portion such as a resist film is provided is referred to as the front surface, and a surface on the opposite side is referred to as the back surface. In addition, the front surface end portion refers to a region having a width of usually 1 to 10 mm from an end of the device portion provided on the substrate to the bevel portion, the bevel portion refers to a curved region (wafer side surface) connecting the front surface end portion and the back surface end portion, and the back surface end portion refers to a region corresponding to the front surface end portion of the back surface of the substrate.

First, the protective-film forming composition is applied to a semiconductor substrate. The method for applying the protective-film forming composition is not particularly limited, but for example, known means such as a spin coating method and a spraying method can be adopted. For example, when a spin coating method is employed, the protective-film forming composition is supplied through a nozzle from above or in the vicinity of the front surface end portion of the rotating disk-shaped substrate while rotating the semiconductor substrate at a predetermined rotation speed. Preferably, the composition is also supplied to the bevel portion and/or the back surface end portion of the substrate from the vicinity of each of the bevel portion and the back surface end portion through a nozzle.

The conditions for spin coating can be appropriately selected and are not limited at all, but examples of typical conditions are as follows.
- Viscosity of protective-film forming composition: about 100 cps or less
- Rotation speed of wafer:
   •• When protective-film forming composition is supplied: 50 to 500 rpm
   •• When shaking off for drying is performed: 700 to 2,000 rpm
- Thickness of protective film: 300 nm

Next, in one embodiment, the protective-film forming composition is exposed to light. The exposure can be performed by irradiating the protective-film forming composition with actinic rays (including the i-line, KrF excimer laser, ArF excimer laser, EUV, and electron beams (EB)) such as ultraviolet rays, visible rays, and radiation through a mask or without a mask. Soft bake (SB) may be performed before exposure, or post exposure bake (PEB) may be performed after exposure and before development. The post exposure bake temperature is preferably 50°C to 150°C, and the post exposure bake time is preferably 1 minute to 10 minutes.

Next, the protective-film forming composition after exposure is developed. The development can be performed by removing the exposed portion of the protective-film forming composition after exposure with a developer and is appropriately selected from a development temperature of 5°C to 50°C and a development time of 10 seconds to 300 seconds.

Examples of an organic solvent contained in the developer include an alcohol-based solvent, an ether-based solvent, a ketone-based solvent, an amide-based solvent, an ester-based solvent, and a hydrocarbon-based solvent. The organic solvent of the developer preferably contains an ester-based solvent, a ketone-based solvent, or a combination thereof. The developer may contain one organic solvent alone or two or more organic solvents.

Examples of the alcohol-based solvent include aliphatic monoalcohol-based solvents having 1 to 18 carbon atoms such as 4-methyl-2-pentanol and n-hexanol; alicyclic monoalcohol-based solvents having 3 to 18 carbon atoms such as cyclohexanol; and polyhydric alcohol partial ether-based solvents having 3 to 19 carbon atoms such as propylene glycol monomethyl ether.

Examples of the ether-based solvent include dialkyl ether-based solvents such as diethyl ether, dipropyl ether, dibutyl ether, dipentyl ether, diisoamyl ether, dihexyl ether, and diheptyl ether; cyclic ether-based solvent such as tetrahydrofuran and tetrahydropyran; and aromatic ring-containing ether-based solvents such as diphenyl ether and anisole.

Examples of the ketone-based solvent include chain ketone-based solvents such as acetone, methyl ethyl ketone, methyl-n-propyl ketone, methyl-n-butyl ketone, diethyl ketone, methyl-iso-butyl ketone, 2-heptanone, ethyl-n-butyl ketone, methyl-n-hexyl ketone, di-iso-butyl ketone, and trimethylnonanone; cyclic ketone-based solvents such as cyclopentanone, cyclohexanone, cycloheptanone, cyclooctanone, and methylcyclohexanone; 2,4-pentanedione, acetonylacetone, and acetophenone.

Examples of the amide-based solvent include cyclic amide-based solvents such as N,N'-dimethylimidazolidinone and N-methylpyrrolidone; and chain amide-based solvents such as N-methylformamide, N,N-dimethylformamide, N,N-diethylformamide, acetamide, N-methylacetamide, N,N-dimethylacetamide, and N-methylpropionamide.

Examples of the ester-based solvent include monocarboxylic acid ester-based solvents such as n-butyl acetate and ethyl lactate; polyhydric alcohol carboxylate-based solvents such as propylene glycol acetate; polyhydric alcohol partial ether carboxylate-based solvents such as propylene glycol monomethyl ether acetate ; polyvalent carboxylic acid diester-based solvents such as diethyl oxalate; and carbonate-based solvents such as dimethyl carbonate and diethyl carbonate.

Examples of the hydrocarbon-based solvent include aliphatic hydrocarbon-based solvents having 5 to 12 carbon atoms such as n-pentane and n-hexane; and aromatic hydrocarbon-based solvents having 6 to 16 carbon atoms such as toluene and xylene.

Among them, an ester-based solvent, a ketone-based solvent, an ether-based solvent, and a combination thereof are preferable, and an ester-based solvent, a ketone-based solvent, and a combination thereof are more preferable. As the ester-based solvent, propylene glycol monomethyl ether acetate is preferable. As the ketone-based solvent, cyclohexanone is preferable. As the ether-based solvent, propylene glycol monomethyl ether is preferable.

The lower limit of the content of the organic solvent in the developer is preferably 80 mass%, more preferably 90 mass%, still more preferably 99 mass%, particularly preferably 100 mass%. By setting the content of the organic solvent in the developer within the above range, the dissolution contrast between the exposed portion and the unexposed portion can be improved.

The developer may contain a nitrogen-containing compound.

As the developer, a developer of an aqueous solution may be used instead of the organic solvent-based developer. Specifically, it may be an aqueous alkaline solution such as sodium hydroxide, potassium hydroxide, sodium silicate, ammonia, monoethylamine, diethylamine, triethylamine, triethanolamine, and tetramethylammonium hydroxide. The base concentration of such an aqueous solution is not particularly limited but can be, for example, 0.1 to 10 mass%.

In addition, alcohols and surfactants may be added to the developer to be used. These can be blended in the range of preferably 0.01 to 10 parts by mass, more preferably 0.1 to 5 parts by mass, on the basis of 100 parts by mass of the developer. Examples of the surfactant include ionic and nonionic fluorine-based surfactants and silicon-based surfactants.

Examples of the developing method include a method in which a substrate is immersed in a developer filled into a tank for a certain period of time (dip method), a method in which a developer is raised on a surface of a substrate by surface tension and is left standing for a certain period of time (puddle method), a method in which a developer is sprayed onto a surface of a substrate (spraying method), and a method in which a developer is continuously applied onto a substrate rotating at a certain speed while a developer application nozzle is allowed to perform a scan at a certain speed (dynamic dispense method).

Next, baking of the protective-film forming composition after development is performed. A desired pattern can be formed by baking the pattern obtained after development. The heating temperature in the heat treatment is usually in the range of 150°C or higher and 350°C or lower, preferably in the range of 200 to 300°C. The heat treatment time is a time until the protective-film forming composition is cured, and is preferably about less than 30 minutes in consideration of productivity.

The lower limit of the thickness of the protective film is preferably 1 nm, more preferably 3 nm. The upper limit of the thickness of the protective film is preferably 500 nm, more preferably 300 nm.

For example, the step (X) is performed before the step (A). Then, for example, in the step (A), a resist film is formed on at least a part of the protective film. In that case, the step (Y) of removing the resist film on the protective film is performed.

In step (Y), the resist film on the protective film can be removed with a removing liquid. At this time, similarly to the step (X), it is preferable to apply the removing liquid to the front surface end portion, the bevel portion, and optionally the back surface end portion of the wafer for semiconductor manufacturing. Examples of the resist removing liquid include propylene glycol monomethyl ether, propylene glycol monomethyl ether acetate, cyclohexanone, water, butyl acetate, a tetramethylammonium aqueous solution, or a mixed solution of a combination thereof. Among them, propylene glycol monomethyl ether acetate and water are preferable from the viewpoint of removability of the resist film.

After the step (X) or the step (Y), a step (Z) of removing the protective film is performed. In the step (Z), the protective film is preferably removed by ashing, or the protective film is preferably removed by treatment with hydrofluoric acid, an organic solvent, an alkaline developer, or a cleaning liquid for a semiconductor. Thereafter, cleaning is preferably performed with an arbitrary solvent, a conventional semiconductor cleaning liquid, or the like.

The steps (X), (Y), and (Z) can be performed simultaneously with the steps (A), (B), and (C) or at any point before or after the corresponding steps. For example, when the step (X) is included before the step (A), the step (Y) of removing the resist film on the protective film can be performed between the step (A) and the step (B), and the step (Z) of removing the protective film can be performed between the step (Y) and the step (B).

When the step (X) is included between the step (A) and the step (B) or step (C), the step (Z) of removing the protective film can be performed between the step (X) and the step (B) or step (C).

### <Step (B)>

In the step (B), a resist pattern is formed by irradiating the resist film with light or an electron beam and subsequently performing development.

The resist film is irradiated with light or an electron beam through a mask (reticle) for forming a predetermined pattern, and for example, the i-line, a KrF excimer laser, an ArF excimer laser, EUV, or EB is used. Soft bake may be performed before exposure, or post exposure bake (PEB) may be performed after exposure and before development. The post exposure bake temperature is preferably 50°C to 150°C, and the post exposure bake time is preferably 1 minute to 10 minutes.

For the development, for example, an alkaline developer is used, the development temperature is appropriately selected from 5°C to 50°C, and the development time is appropriately selected from 10 seconds to 300 seconds. As the alkaline developer, for example, an aqueous solution of an alkali such as an inorganic alkali such as sodium hydroxide, potassium hydroxide, sodium carbonate, sodium silicate, sodium metasilicate, and ammonia water; a primary amine such as ethylamine and n-propylamine; a secondary amine such as diethylamine and di-n-butylamine; a tertiary amine such as triethylamine and methyldiethylamine; an alcoholamine such as dimethylethanolamine and triethanolamine; a quaternary ammonium salt such as tetramethylammonium hydroxide, tetraethylammonium hydroxide, and choline; and a cyclic amine such as pyrrole and piperidine can be used. The base concentration of such an aqueous solution is not particularly limited but can be, for example, 0.1 to 10 mass%.

Furthermore, it is also possible to add an appropriate amount of an alcohol such as isopropyl alcohol or a nonionic surfactant to the aqueous solution of an alkali. These can be blended in the range of preferably 0.01 to 10 parts by mass, more preferably 0.1 to 5 parts by mass, on the basis of 100 parts by mass of the developer. Among them, preferable developers are quaternary ammonium salts, more preferably tetramethylammonium hydroxide and choline. Furthermore, a surfactant or the like can be added to these developers.

In place of the alkali developer, a method can also be used in which development is performed with a polyhydric alcohol-based solvent having 2 to 18 carbon atoms such as 1,2-propylene glycol or an organic solvent such as butyl acetate, so that a portion of the resist where the alkali dissolution rate is not improved is developed.

The semiconductor substrate subjected to the exposure and development is baked. Means for baking is not particularly limited, but for example, a proximity bake furnace for securing a gap using a plurality of substrate support pins between a substrate and a hot plate is suitably used.

The baking temperature is usually 40°C to 300°C, preferably 200 to 300°C for 1 to 30 minutes, but may be set to 90°C or lower when it is necessary to avoid damage to the resist pattern.

The baking may be performed on the semiconductor substrate before the PEB. Means and conditions of baking are as described above but may be set to 90°C or lower when it is necessary to avoid damage to the resist pattern.

### <Step (C)>

In the step (C), the semiconductor substrate is processed by etching using the resist pattern as a mask.

For example, the semiconductor substrate is processed by etching using the formed resist pattern as a mask.

Alternatively, for example, using the formed resist pattern as a mask, the resist underlayer film is etched, preferably dry-etched, to form a patterned resist. At that time, when the inorganic film is formed on the surface of the used semiconductor substrate, the surface of the inorganic film is exposed, and when the inorganic film is not formed on the surface of the used semiconductor substrate, the surface of the semiconductor substrate is exposed. Thereafter, the semiconductor substrate is processed with the patterned resist by a method known per se (such as the dry etching method).

The etching for processing the semiconductor substrate may be a known method. For example, when the semiconductor substrate is a silicon substrate, the etching also includes a surface treatment step such as removing a silicon nitride film present on a surface of the semiconductor substrate with hot phosphoric acid in addition to a step of performing shape processing by dry etching using a fluorine-based gas such as carbon tetrafluoride.

A semiconductor device can be manufactured through the above steps.

### (Method for Manufacturing Wafer for Semiconductor Manufacturing)

The method for manufacturing a wafer for semiconductor manufacturing of the present invention includes a step of applying the protective-film forming composition of the present invention to an end portion of a wafer precursor to manufacture a wafer in which a front surface end portion and a bevel portion are protected by the formed protective film.

The protective-film forming composition is applied to, for example, the front surface end portion, the bevel portion, and optionally the back surface end portion of the wafer precursor.

The wafer precursor refers to a precursor obtained by subjecting a semiconductor substrate to at least one step of the method for manufacturing a semiconductor device. For example, in the method for manufacturing a semiconductor device as described above, a material that has been subjected to a step of forming the inorganic film, the resist underlayer film, the resist film, and the like on a semiconductor substrate and is not yet subjected to, for example, a step of forming the resist pattern by irradiation of the resist film with light or an electron beam and subsequent development can be cited.

In one embodiment, the protective-film forming composition of the present invention is applied by spin coating to the front surface end portion, the bevel part, and optionally the back surface end portion of the wafer precursor obtained through one or more steps of the semiconductor device manufacturing process.

Thereafter, the semiconductor substrate may be baked. In this case, means for baking is not particularly limited, but for example, a proximity bake furnace for securing a gap using a plurality of substrate support pins between a substrate and a hot plate is suitably used. The baking temperature is usually 40°C to 300°C, preferably 200 to 300°C, for 1 to 30 minutes.

After the protective-film forming composition is applied, the end surface of the protective film may be subjected to a known treatment in a semiconductor manufacturing process, such as edge bead removal and backside rinse.

### (Wafer for Semiconductor Manufacturing)

The wafer for semiconductor manufacturing of the present invention is a wafer for semiconductor manufacturing whose wafer end is protected, and is formed by applying the protective-film forming composition of the present invention to the wafer end.

### Examples

Hereinafter, the present invention will be described more specifically with reference to synthesis examples and examples, but the present invention is not limited to only the following examples.

In the examples, devices and conditions used for analyzing physical properties of a sample were as follows.

### (1) Molecular Weight Measurement

The molecular weight used in the present invention is a molecular weight obtained in terms of polystyrene by GPC analysis.

GPC measurement was performed using a GPC apparatus (trade name: HLC-8320GPC, manufactured by Tosoh Corporation), a GPC column (TSKgel SuperMultiporeHZ-N (2 columns)), a column temperature of 40°C, an eluent (eluent solvent) of tetrahydrofuran, a flow rate (flow speed) of 0.35 mL/min, and polystyrene (manufactured by Sigma-Aldrich) as a standard sample.

### (2) Evaporation Rate

The evaporation rate used in the present invention is an evaporation rate obtained according to ASTM D 3539. However, the numerical value of the evaporation rate used in the present invention is a relative value with respect to the evaporation rate of n-butyl acetate. That is, the numerical value of the evaporation rate used in the present invention is a value obtained by dividing the evaporation rate of the solvent by the evaporation rate of n-butyl acetate.

The evaporation rates (n-butyl acetate = 1) of the solvents used in the following examples are as follows.
Propylene glycol monomethyl ether (evaporation rate: 0.71)
Propylene glycol monomethyl ether acetate (evaporation rate: 0.34)
Ethyl lactate (evaporation rate: 0.23)
Dipropylene glycol methyl ether (evaporation rate: 0.03)
1,3-Butylene glycol diacetate (evaporation rate: 0.01 or less)

### [1] Polymer Synthesis

### <Synthesis Example 1>

To 50.00 g of EOCN-104S (product name) (manufactured by Nippon Kayaku Co., Ltd.), 16.60 g of acrylic acid, 2.93 g of tetrabutylphosphonium bromide, and 0.13 g of hydroquinone, 162.54 g of propylene glycol monomethyl ether acetate (PGMEA) was added, and the mixture was heated and stirred at 100°C for 18 hours under a nitrogen atmosphere. To the resulting solution, 70 g of an anion exchange resin (product name: DOWEX [registered trademark] 550A, Muromachi Technos Co., Ltd.) and 70 g of a cation exchange resin (product name: AMBERLITE [registered trademark] 15JWET, Organo Corporation) were added, and ion exchange treatment was performed at room temperature for 4 hours. After the ion exchange resins were separated, a compound solution was obtained. The repeating unit of the obtained compound corresponded to the following formula, and the weight average molecular weight measured in terms of standard polystyrene by GPC was 5,100.

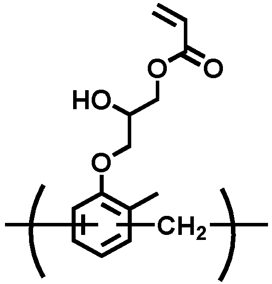

### <Synthesis Example 2>

To 15.00 g of EOCN-104S (product name) (manufactured by Nippon Kayaku Co., Ltd.), 4.98 g of acrylic acid, 0.88 g of tetrabutylphosphonium bromide, and 0.04 g of hydroquinone, 48.76 g of propylene glycol monomethyl ether (PGME was added, and the mixture was heated and stirred at 100°C for 18 hours under a nitrogen atmosphere. To the resulting solution, 20 g of an anion exchange resin (product name: DOWEX [registered trademark] 550A, Muromachi Technos Co., Ltd.) and 20 g of a cation exchange resin (product name: AMBERLITE [registered trademark] 15JWET, Organo Corporation) were added, and ion exchange treatment was performed at room temperature for 4 hours. After the ion exchange resins were separated, a compound solution was obtained. The repeating unit of the obtained compound corresponded to the following formula, and the weight average molecular weight measured in terms of standard polystyrene by GPC was 6,100.

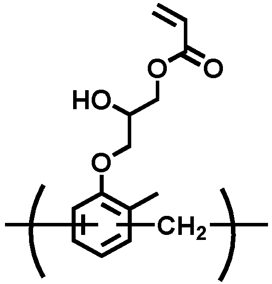

### <Synthesis Example 3>

To 15.00 g of EOCN-104S (product name) (manufactured by Nippon Kayaku Co., Ltd.), 4.98 g of acrylic acid, 0.88 g of tetrabutylphosphonium bromide, and 0.04 g of hydroquinone, 48.46 g of dipropylene glycol methyl ether (DPM) was added, and the mixture was heated and stirred at 100°C for 18 hours under a nitrogen atmosphere. To the resulting solution, 20 g of an anion exchange resin (product name: DOWEX [registered trademark] 550A, Muromachi Technos Co., Ltd.) and 20 g of a cation exchange resin (product name: AMBERLITE [registered trademark] 15JWET, Organo Corporation) were added, and ion exchange treatment was performed at room temperature for 4 hours. After the ion exchange resins were separated, a compound solution was obtained. The repeating unit of the obtained compound corresponded to the following formula, and the weight average molecular weight measured in terms of standard polystyrene by GPC was 7,600.

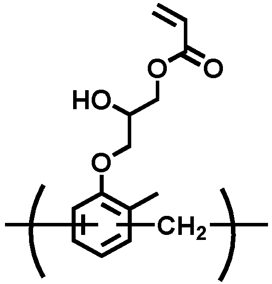

### <Synthesis Example 4>

To 15.00 g of EOCN-104S (product name) (manufactured by Nippon Kayaku Co., Ltd.), 4.98 g of acrylic acid, 0.88 g of tetrabutylphosphonium bromide, and 0.04 g of hydroquinone, 48.46 g of ethyl lactate (EL) was added, and the mixture was heated and stirred at 100°C for 18 hours under a nitrogen atmosphere. To the resulting solution, 20 g of an anion exchange resin (product name: DOWEX [registered trademark] 550A, Muromachi Technos Co., Ltd.) and 20 g of a cation exchange resin (product name: AMBERLITE [registered trademark] 15JWET, Organo Corporation) were added, and ion exchange treatment was performed at room temperature for 4 hours. After the ion exchange resins were separated, a compound solution was obtained. The obtained compound corresponded to the following formula, and the weight average molecular weight measured in terms of standard polystyrene by GPC was 4,100.

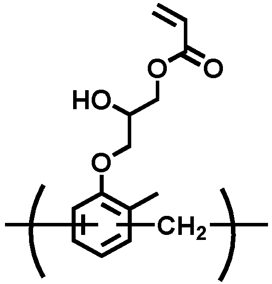

### [2] Preparation of Protective-Film Forming Composition

### <Preparation Example 1>

To 13.79 g of the resin solution (solid content: 24.26 mass%) obtained in Synthesis Example 1, 0.33 g of Irgacure Oxe-01 (manufactured by BASF Japan Ltd.) as a photopolymerization initiator, 0.10 g of a 10-mass% PGMEA solution of MEGAFACE R-30 (manufactured by Dainippon Ink and Chemicals, Inc.) as a surfactant, 0.05 g of Irganox 3114 (manufactured by BASF Japan Ltd.) as an antioxidant, and 5.72 g of PGMEA were added and mixed, and the solution was filtered using a microfilter made of polytetrafluoroethylene having a pore diameter of 0.2 µm to obtain a protective-film forming composition.

### <Preparation Example 2>

To 13.37 g of the resin solution (solid content: 25.02 mass%) obtained in Synthesis Example 2, 0.33 g of Irgacure Oxe-01 (manufactured by BASF Japan Ltd.) as a photopolymerization initiator, 0.10 g of a 10-mass% PGME solution of MEGAFACE R-30 (manufactured by Dainippon Ink and Chemicals, Inc.) as a surfactant, 0.05 g of Irganox 3114 (manufactured by BASF Japan Ltd.) as an antioxidant, and 6.14 g of PGME were added and mixed, and the solution was filtered using a microfilter made of polytetrafluoroethylene having a pore diameter of 0.2 µm to obtain a protective-film forming composition.

### <Preparation Example 3>

To 13.13 g of the resin solution (solid content: 25.47 mass%) obtained in Synthesis Example 3, 0.33 g of Irgacure Oxe-01 (manufactured by BASF Japan Ltd.) as a photopolymerization initiator, 0.10 g of a 10-mass% DPM solution of MEGAFACE R-30 (manufactured by Dainippon Ink and Chemicals, Inc.) as a surfactant, 0.05 g of Irganox 3114 (manufactured by BASF Japan Ltd.) as an antioxidant, and 6.38 g of DPM were added and mixed, and the solution was filtered using a microfilter made of polytetrafluoroethylene having a pore diameter of 0.2 µm to obtain a protective-film forming composition.

### <Preparation Example 4>

To 13.79 g of the resin solution (solid content: 24.26 mass%) obtained in Synthesis Example 1, 0.33 g of Irgacure Oxe-01 (manufactured by BASF Japan Ltd.) as a photopolymerization initiator, 0.10 g of a 10-mass% PGMEA solution of MEGAFACE R-30 (manufactured by Dainippon Ink and Chemicals, Inc.) as a surfactant, 0.05 g of Irganox 3114 (manufactured by BASF Japan Ltd.) as an antioxidant, 2.47 g of PGMEA, and 3.25 g of DPM were added and mixed, and the solution was filtered using a microfilter made of polytetrafluoroethylene having a pore diameter of 0.2 µm to obtain a protective-film forming composition.

### <Preparation Example 5>

To 13.14 g of the resin solution (solid content: 26.56 mass%) obtained in Synthesis Example 4, 0.34 g of Irgacure Oxe-01 (manufactured by BASF Japan Ltd.) as a photopolymerization initiator, 0.10 g of a 10-mass% EL solution of MEGAFACE R-30 (manufactured by Dainippon Ink and Chemicals, Inc.) as a surfactant, 0.05 g of Irganox 3114 (manufactured by BASF Japan Ltd.) as an antioxidant, and 6.36 g of EL were added and mixed, and the solution was filtered using a microfilter made of polytetrafluoroethylene having a pore diameter of 0.2 µm to obtain a protective-film forming composition.

### <Preparation Example 6>

To 13.79 g of the resin solution (solid content: 24.26 mass%) obtained in Synthesis Example 1, 0.33 g of Irgacure Oxe-01 (manufactured by BASF Japan Ltd.) as a photopolymerization initiator, 0.10 g of a 10-mass% PGMEA solution of MEGAFACE R-30 (manufactured by Dainippon Ink and Chemicals, Inc.) as a surfactant, 0.05 g of Irganox 3114 (manufactured by BASF Japan Ltd.) as an antioxidant, 2.47 g of PGMEA, and 3.25 g of 1,3-Butylene glycol diacetate (1,3-BGDA) were added and mixed, and the solution was filtered using a microfilter made of polytetrafluoroethylene having a pore diameter of 0.2 µm to obtain a protective-film forming composition.

### [3] Observation of Wafer Edge Side Surface (Bevel Portion) After Application

As Comparative Examples 1 to 4 and Examples 1 to 2, the protective-film forming compositions prepared in Preparation Examples 1 to 6 were each subjected to spin coating with a film thickness of 900 nm on a silicon substrate to form a protective film. The edge side surface (bevel portion) of the silicon substrate was observed for the shape of the protective film on the edge side surface of the silicon substrate using a scanning electron microscope (S-4800) manufactured by Hitachi High-Technologies Corporation (magnification: 50 times). The case where no abnormal shape (partial swelling or recess) was observed in the protective film was rated as "o", and the case where an abnormal shape (partial swelling or recess) was observed in the protective film was rated as "×". The results are shown in Table 2 described below.

### [4] Observation of Wafer Edge Portion (Front Surface End Portion) After Application

As Comparative Examples 1 to 4 and Examples 1 to 2, the protective-film forming compositions prepared in Preparation Examples 1 to 6 were each subjected to spin coating with a film thickness of 900 nm on a silicon substrate to form a protective film. The film shape of the edge portion (front surface end portion) of the silicon substrate was observed using Dektak XT-A manufactured by Bruker Corporation, and the covering property of the coating film was evaluated. The sample was rated as "o" when the covering property was good, "Δ" when the covering property was slightly poor, and "×" when the covering property was poor, and the results are shown in Table 2 described later.

Here, the good covering property means that the thickness of the protective film at a position 500 µm inside from the outermost end of the front surface of a wafer is 80% or more of the thickness of the protective film at a position 1,500 µm inside from the outermost end.

The slightly poor covering property means that the thickness of the protective film at a position 500 µm inside from the outermost end of the front surface of the wafer is 30% or more and less than 80% of the thickness of the protective film at a position 1,500 µm inside from the outermost end.

The poor covering property means that the thickness of the protective film at a position 500 µm inside from the outermost end of the front surface of the wafer is less than 30% of the thickness of the protective film at a position 1,500 µm inside from the outermost end.

### [5] Evaluation of Curability After Exposure

As Comparative Examples 1 to 4 and Examples 1 to 2, each of the protective-film forming compositions prepared in Preparation Examples 1 to 6 was subjected to spin coating on a silicon wafer, and then the wafer edge portion was exposed to mercury lamp light at an exposure value of 130 mJ/cm² (254 nm wavelength) using a wafer edge exposure module (WEE) of a coater/developer Lithius Pro manufactured by Tokyo Elecroton Ltd. After the exposure, development was performed for 30 seconds using OK73 Thinner (manufactured by Tokyo Ohka Kogyo Co., Ltd.) as a developer to form a pattern on the wafer edge portion.

Using an optical interference type film thickness measuring apparatus (VM-3210) manufactured by SCREEN Holdings Co., Ltd., the film thickness after coating and the film thickness of the pattern remaining after development were measured, and the residual film ratio after development (film thickness after development/film thickness after coating) was calculated. The results are shown in Table 2.

### [6] Viscosity Measurement

The viscosity of each protective-film forming composition was measured at 25°C using an E-type viscometer (TVE-22L (manufactured by Toki Sangyo Co., Ltd.), sample amount: 1.1 mL, cone rotor: 1°34', R24). The results are shown in Table 2.

**[Table 2]**

| | Protective-film forming composition | | | Film state of edge end surface | Edge portion covering property | Residual film ratio (%) | Viscosity (cps) |
|---|---|---|---|---|---|---|---|
| | | Content of solvent (mass%) | Composition of solvent | | | | |
| Comparative Example 1 | Preparation Example 1 | 82 | PGMEA: 100 mass% | × | ○ | 93 | 3.7 |
| Comparative Example 2 | Preparation Example 2 | 85 | PGME: 100 mass% | × | ○ | 90 | 4.4 |
| Comparative Example 3 | Preparation Example 3 | 81 | DPM: 100 mass% | ○ | × | N/A | 11.4 |
| Example 1 | Preparation Example 4 | 82 | PGMEA : DPM = 80 : 20 (mass ratio) | ○ | ○ | 93 | 4.5 |
| Comparative Example 4 | Preparation Example 5 | 83 | EL: 100 mass% | × | ○ | 92 | 7.1 |
| Example 2 | Preparation Example 6 | 82 | PGMEA : 1,3-BGDA = 80 : 20 (mass ratio) | ○ | ○ | 92 | 4.4 |

| | | | | | | | |
|---|---|---|---|---|---|---|---|
| N/A indicates that the film thickness after coating was thin, and evaluation was impossible. | | | | | | | |

## Claims

1. A wafer end protective-film forming composition for semiconductor manufacturing, comprising:
a polymer or compound having a crosslinkable group, and
a solvent,
wherein the solvent contains a first solvent and a second solvent, and
when an evaporation rate of n-butyl acetate is 1, an evaporation rate of the first solvent is 0.10 or more and an evaporation rate of the second solvent is 0.05 or less.

2. The wafer end protective-film forming composition for semiconductor manufacturing according to claim 1, wherein a mass ratio (S1 : S2) between the first solvent (S1) and the second solvent (S2) is 50 : 50 to 95 : 5.

3. The wafer end protective-film forming composition for semiconductor manufacturing according to claim 1, wherein a difference (V1 - V2) between the evaporation rate (V1) of the first solvent and the evaporation rate (V2) of the second solvent is 0.10 or more.

4. The wafer end protective-film forming composition for semiconductor manufacturing according to claim 1,
wherein constituent elements of the first solvent are carbon, oxygen, and hydrogen, and
constituent elements of the second solvent are carbon, oxygen, and hydrogen.

5. The wafer end protective-film forming composition for semiconductor manufacturing according to claim 1, wherein a content of the solvent is 70 mass% to 99 mass%.

6. The wafer end protective-film forming composition for semiconductor manufacturing according to claim 1, having a viscosity of 100 cps or less at 25°C.

7. The wafer end protective-film forming composition for semiconductor manufacturing according to claim 1, which is photosensitive.

8. The wafer end protective-film forming composition for semiconductor manufacturing according to claim 1, wherein the crosslinkable group is selected from the group consisting of an epoxy group, a (meth)acrylic group, a vinyl group, a carboxy group, a thiol group, a silanol group, a cinnamoyl group, and a hydroxy group.

9. A protective film that is a cured product of a coating film formed of the wafer end protective-film forming composition for semiconductor manufacturing according to any one of claims 1 to 8.

10. The protective film according to claim 9, having a thickness of 1 to 10,000 nm.

11. The protective film according to claim 9, which is a protective film preventing metal contamination of a front surface end portion and a bevel portion of a wafer.

12. The protective film according to claim 9, which is cured by being irradiated with light having a wavelength of 170 to 800 nm.

13. A wafer for semiconductor manufacturing, comprising a front surface end portion and a bevel portion of a wafer protected, wherein a protective film is formed by applying the wafer end protective-film forming composition for semiconductor manufacturing according to any one of claims 1 to 8 to the front surface end portion and the bevel portion of a wafer precursor.

14. A method for manufacturing a semiconductor device, the method comprising:
a step (A) of forming a resist film on a semiconductor substrate;
a step (B) of forming a resist pattern by irradiating the resist film with light or an electron beam and subsequently performing development;
a step (C) of etching the semiconductor substrate using the resist pattern as a mask; and
a step (X) of forming a protective film on a front surface end portion, a bevel portion, and optionally a back surface end portion of a wafer for semiconductor manufacturing using the wafer end protective-film forming composition for semiconductor manufacturing according to any one of claims 1 to 8.

15. The method for manufacturing a semiconductor device according to claim 14, wherein the step (X) is performed before the step (A).

16. The method for manufacturing a semiconductor device according to claim 14, wherein the step (X) is performed between the step (A) and the step (B).

17. The method for manufacturing a semiconductor device according to claim 14, wherein the step (X) is performed after the step (B) or the step (C).

18. The method for manufacturing a semiconductor device according to claim 14,
wherein the step (X) is performed before the step (A),
the resist film is formed on at least a part of the protective film in the step (A), and
a step (Y) of removing the resist film on the protective film is included.

19. The method for manufacturing a semiconductor device according to claim 14, comprising a step (Z) of removing the protective film.

20. The method for manufacturing a semiconductor device according to claim 18, comprising a step (Z) of removing the protective film after the step (Y).

21. The method for manufacturing a semiconductor device according to claim 14, wherein the resist film contains a metal.

22. The method for manufacturing a semiconductor device according to claim 14,
wherein the wafer end protective-film forming composition for semiconductor manufacturing is photosensitive, and
formation of the protective film in the step (X) is performed by applying the wafer end protective-film forming composition for semiconductor manufacturing, and performing exposure on a predetermined region and development.

23. The method for manufacturing a semiconductor device according to claim 14, wherein formation of the protective film in the step (X) is performed by spin-coating with the wafer end protective-film forming composition for semiconductor manufacturing.

24. The method for manufacturing a semiconductor device according to claim 19, wherein the protective film is removed in the step (Z) by ashing or by treatment with hydrofluoric acid, an organic solvent, an alkaline developer, or a cleaning liquid for a semiconductor.

25. A method for manufacturing a wafer for semiconductor manufacturing, the method comprising:
a step of applying the wafer end protective-film forming composition for semiconductor manufacturing according to any one of claims 1 to 8 to an end portion of a wafer precursor to manufacture a wafer including a front surface end portion and a bevel portion protected by a protective film formed.
